# EUROPEAN PATENT APPLICATION

(11) **EP 4 261 907 A1**
(43) Date of publication of application: **18.10.2023**
(21) Application number: 21922475.5
(22) Date of filing: 19.11.2021
(51) Int. Cl.: H01L 51/05, H01L 51/40, H01L 29/786

(54) **THIN FILM TRANSISTOR, MEMORY AND MANUFACTURING METHOD, AND ELECTRONIC DEVICE**

(30) Priority: 26.01.2021 CN 202110106685
(71) Applicant: Huawei Technologies Co., Ltd., Shenzhen, Guangdong 518129 (CN)
(72) Inventor: JING, Weiliang, Shenzhen, Guangdong 518129 (CN); HUANG, Kailiang, Shenzhen, Guangdong 518129 (CN); FENG, Junxiao, Shenzhen, Guangdong 518129 (CN); WANG, Zhengbo, Shenzhen, Guangdong 518129 (CN)
(74) Representative: Grünecker Patent- und Rechtsanwälte PartG mbB
(86) International application number: PCT/CN2021/131913
(87) International publication number: WO 2022/160885

(57) **Abstract**

Embodiments of this application provide a thin film transistor and a manufacturing method, a memory and a manufacturing method, and an electronic device, and relate to the field of memory technologies, to reduce a size of the thin film transistor, improve area utilization, and reduce routing difficulty. The thin film transistor includes a gate, a first electrode, a second electrode, a first dielectric layer, a second dielectric layer, and a semiconductor layer. The gate includes a gate base located at a top portion and a gate body extending from the gate base to a bottom portion. The first electrode is located at the bottom portion. The second electrode is located between the first electrode and the gate base. The first dielectric layer is disposed between the second electrode and the first electrode, and the first dielectric layer is configured to separate the first electrode from the second electrode. The second dielectric layer covers a surface of the gate base and a surface of the gate body. The semiconductor layer is disposed along a side surface of the gate body, and the second dielectric layer separates the semiconductor layer from the gate. The first electrode and the second electrode are electrically connected to the semiconductor layer respectively.

## Description

### CROSS-REFERENCE TO RELATED APPLICATIONS

This application claims priority to Chinese Patent Application No. 202110106685.8, filed with the China National Intellectual Property Administration on January 26, 2021 and entitled "THIN FILM TRANSISTOR AND MANUFACTURING METHOD, MEMORY AND MANUFACTURING METHOD, AND ELECTRONIC DEVICE", which is incorporated herein by reference in its entirety.

### TECHNICAL FIELD

This application relates to the field of memory technologies, and in particular, to a thin film transistor and a manufacturing method, a memory and a manufacturing method, and an electronic device.

### BACKGROUND

A thin film transistor (thin film transistor, TFT) has advantages of a low leakage current, a low growth temperature, and a high mobility, and therefore the thin film transistor has been widely used in various devices such as a memory.

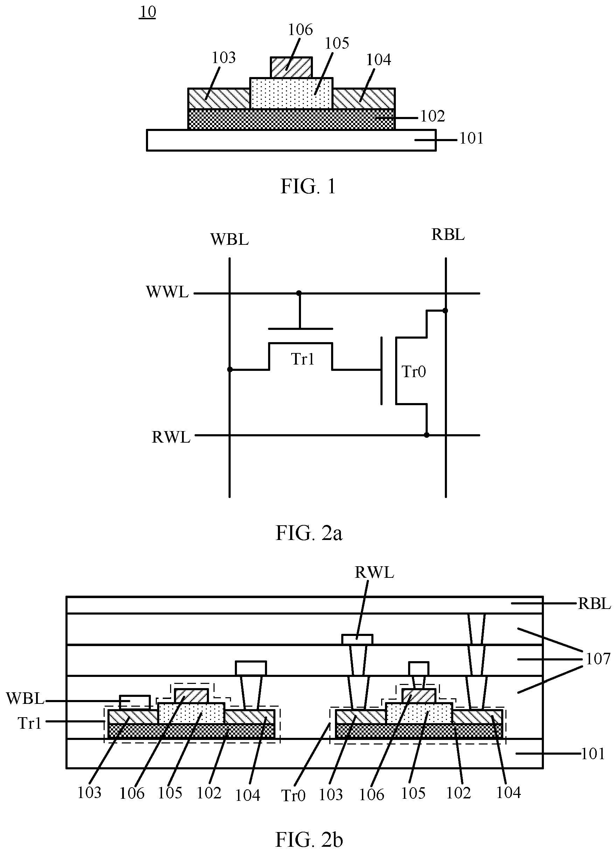

A structure of an existing thin film transistor is shown in FIG. 1. The thin film transistor 10 includes a semiconductor layer (which may also be referred to as an active layer) 102 disposed on a substrate 101, a source 103 and a drain 104 that are disposed on the semiconductor layer 102 and in contact with the semiconductor layer 102, a gate insulation layer 105 disposed on the semiconductor layer 102, and a gate 106 disposed on the gate insulation layer 105.

Because the semiconductor layer 102 of the existing thin film transistor 10 is spread along a plane parallel to the gate 106, and the source 103 and the drain 104 are located at a same layer, a size of the thin film transistor 10 is relatively large, and area utilization is low. In addition, because the source electrode 103 and the drain electrode 104 are located at the same layer, a short circuit easily occurs during routing of a signal line electrically connected to the source electrode 103 and a signal line electrically connected to the drain electrode 104, which is not conducive to routing and increases process difficulty.

### SUMMARY

Embodiments of this application provide a thin film transistor and a manufacturing method, a memory and a manufacturing method, and an electronic device, to reduce a size of the thin film transistor, improve area utilization, and reduce routing difficulty.

To achieve the foregoing objectives, this application uses the following technical solutions.

According to a first aspect, a thin film transistor is provided. The thin film transistor includes a gate, a first electrode, a second electrode, a first dielectric layer, a second dielectric layer, and a semiconductor layer. The gate includes a gate base located at a top portion and a gate body extending from the gate base to a bottom portion. The first electrode is located at the bottom portion. The second electrode is located between the first electrode and the gate base. The first dielectric layer is disposed between the second electrode and the first electrode, and the first dielectric layer is configured to separate the first electrode from the second electrode. The semiconductor layer is disposed along a side surface of the gate body, and the second dielectric layer separates the semiconductor layer from the gate. The first electrode and the second electrode are electrically connected to the semiconductor layer respectively.

Compared with the conventional technology, the semiconductor layer is disposed along a plane parallel to the gate (the gate in the conventional technology is equivalent to the gate base in this embodiment of this application), and the second electrode and the first electrode are disposed at a same layer. In this embodiment of this application, the semiconductor layer is disposed along the side surface of the gate body, the first electrode is located at the bottom portion, the second electrode is located between the first electrode and the gate base, and the first electrode and the second electrode are electrically connected to the semiconductor layer respectively. Therefore, the thin film transistor provided in this embodiment of this application has a relatively small size on a plane parallel to the gate base. Therefore, in this embodiment of this application, the size of the thin film transistor is reduced, and area utilization is improved. In addition, because the second electrode and the first electrode of the thin film transistor in this embodiment of this application are located at different layers, a short circuit occurring during routing of a signal line electrically connected to the second electrode and a signal line electrically connected to the first electrode may be avoided, thereby reducing process difficulty.

In a possible implementation, the second electrode is disposed close to the gate base. This can avoid that the first electrode and the second electrode are directly conducted when the first electrode and the second electrode are manufactured.

In a possible implementation, a boundary of a projection of the gate body on the gate base is located within a boundary of the gate base. In this case, the gate body is disposed in a middle region of the gate base.

In a possible implementation, a boundary of a projection of the gate body on the gate base partially overlaps a boundary of the gate base. In this case, the gate body is disposed in an edge region of the gate base.

In a possible implementation, the gate body is of a hollow structure, and an outer boundary of a projection of the gate body on the gate base overlaps a boundary of the gate base. Because the gate body is of a hollow structure, the second dielectric layer, the semiconductor layer, the second electrode, and the first dielectric layer may be disposed in the hollow structure.

In a possible implementation, the semiconductor layer further includes an extension portion extending along a surface of the gate base. In this way, an area of the semiconductor layer may be increased, thereby increasing an electrical connection area between the semiconductor layer and the second electrode, and improving a switching rate of the thin film transistor.

In a possible implementation, the semiconductor layer further includes an extension portion located between the gate body and the first electrode. In this way, an area of the semiconductor layer may be increased, thereby increasing an electrical connection area between the semiconductor layer and the first electrode, and improving a switching rate of the thin film transistor.

In a possible implementation, the semiconductor layer is disposed around the entire side surface of the gate body. In this way, an area of the semiconductor layer may be increased, and a switching rate of the thin film transistor is improved.

In a possible implementation, the semiconductor layer surrounds an entire side surface of the gate body.

In a possible implementation, the second electrode is disposed on a side of the semiconductor layer that is away from the second dielectric layer.

In a possible implementation, the second electrode is disposed between the semiconductor layer and the second dielectric layer.

In a possible implementation, a material of the second dielectric layer is a ferroelectric material, and the thin film transistor further includes a third dielectric layer disposed between the semiconductor layer and the second dielectric layer. The gate, the second dielectric layer, and the third dielectric layer may form a composite gate structure. By using the composite gate structure, the thin film transistor may implement performance of a negative capacitance transistor, and a gate control capability of the thin film transistor may be improved by using the negative capacitance. When the thin film transistor is used in a memory, performance of the memory may be improved.

In a possible implementation, the thin film transistor further includes a first conductive layer disposed between the second dielectric layer and the third dielectric layer. A composite gate structure including the gate, the second dielectric layer, the first conductive layer, and the third dielectric layer may enable the thin film transistor to implement performance of a negative capacitance transistor, and a gate control capability of the thin film transistor may be improved by using the negative capacitance. When the thin film transistor is used in a memory, performance of the memory may be improved.

In a possible implementation, the thin film transistor further includes a fourth dielectric layer disposed between the second electrode and the semiconductor layer, and/or a fifth dielectric layer disposed between the first electrode and the semiconductor layer. The fourth dielectric layer is disposed between the second electrode and the semiconductor layer, so as to avoid a problem of diffusion of the second electrode in a contact region with the semiconductor layer, and reduce a Fermi level pinning problem of contact between the second electrode and the semiconductor layer. The fifth dielectric layer is disposed between the first electrode and the semiconductor layer, so as to avoid a problem of diffusion of the first electrode in a contact region with the semiconductor layer, and reduce a Fermi level pinning problem of contact between the first electrode and the semiconductor layer.

In a possible implementation, thicknesses of both the fourth dielectric layer and the fifth dielectric layer range from 0.1 nm to 2 nm. This can ensure that when a voltage is provided on the gate, the second electrode and the first electrode can be conducted through the semiconductor layer, and performance of the thin film transistor is not affected.

In a possible implementation, the thin film transistor further includes a modulation gate electrode disposed between the first electrode and the second electrode, the modulation gate electrode is disposed on a side of the semiconductor layer that is away from the gate body, and the modulation gate electrode is surrounded by the first dielectric layer, so that the modulation gate electrode is spaced from the first electrode, the second electrode, and the semiconductor layer. A threshold voltage of the thin film transistor may be adjusted by using the modulation gate electrode.

In a possible implementation, the first electrode is a drain, and the second electrode is a source; or the first electrode is a source, and the second electrode is a drain.

According to a second aspect, a memory is provided. The memory includes at least one layer of storage array disposed on a substrate, where each layer of storage array includes a plurality of storage cells, write word lines, write bit lines, read word lines, and read bit lines that are distributed in an array; the storage cell includes a second thin film transistor and a first thin film transistor that are stacked; a gate of the second thin film transistor is electrically connected to the write word line, and a second electrode is electrically connected to the write bit line; and a second electrode and a first electrode of the first thin film transistor are electrically connected to the read word line and the read bit line respectively. The second thin film transistor and the first thin film transistor are the foregoing thin film transistors. A first electrode of the second thin film transistor is close to a gate of the first thin film transistor, and the first electrode of the second thin film transistor is electrically connected to the gate of the first thin film transistor. Because the second thin film transistor and the first thin film transistor in the memory are the foregoing thin film transistors, and the second thin film transistor and the first thin film transistor have the same technical effects as those in the foregoing embodiments, details are not described herein again.

In a possible implementation, the storage cell further includes a connection electrode disposed between the first thin film transistor and the second thin film transistor, and the gate of the first thin film transistor is electrically connected to the first electrode of the second thin film transistor by using the connection electrode.

In a possible implementation, gates of second thin film transistors in a plurality of storage cells that are sequentially arranged in each layer of storage array along a first direction are electrically connected to a same write word line, and second electrodes of second thin film transistors in a plurality of storage cells that are sequentially arranged in each layer of storage array along a second direction are electrically connected to a same write bit line, where the first direction intersects with the second direction. In each layer of storage array, the gates of the second thin film transistors in the plurality of storage cells that are sequentially arranged along the first direction are electrically connected to a same write word line, and the second electrodes of the second thin film transistors in the plurality of storage cells that are sequentially arranged along the second direction are electrically connected to a same write bit line. Therefore, in a write operation process, a first switch signal may be provided to the plurality of write word lines row by row, so that the plurality of rows of second thin film transistors are turned on row by row. In a case that the first switch signal is provided to a write word line of a current row, logical information is simultaneously written, by using a plurality of write bit lines, to a plurality of storage cells that are electrically connected to the write word line of the current row, so that the logical information may be written to the storage cells row by row, thereby implementing quick writing of the plurality of storage cells in the storage array.

In a possible implementation, second electrodes of first thin film transistors in the plurality of storage cells that are sequentially arranged in each layer of storage array along the first direction are electrically connected to a same read bit line, and first electrodes of first thin film transistors in the plurality of storage cells that are sequentially arranged in each layer of storage array along the second direction are electrically connected to a same read word line; second electrodes of first thin film transistors in the plurality of storage cells that are sequentially arranged in each layer of storage array along the first direction are electrically connected to a same read word line, and first electrodes of first thin film transistors in the plurality of storage cells that are sequentially arranged in each layer of storage array along the second direction are electrically connected to a same read bit line; second electrodes of first thin film transistors in the plurality of storage cells that are sequentially arranged in each layer of storage array along the second direction are electrically connected to a same read bit line, and first electrodes of first thin film transistors in the plurality of storage cells that are sequentially arranged in each layer of storage array along the first direction are electrically connected to a same read word line; or second electrodes of first thin film transistors in the plurality of storage cells that are sequentially arranged in each layer of storage array along the second direction are electrically connected to a same read word line, and first electrodes of first thin film transistors in the plurality of storage cells that are sequentially arranged in each layer of storage array along the first direction are electrically connected to a same read bit line, where the first direction intersects with the second direction. In a read operation process, a third level signal may be provided to the plurality of read word lines row by row. In a case that the third level signal is provided to a read word line of a current row, a current on each read bit line is detected. In this way, logical information stored in a plurality of storage cells that are electrically connected to the read word line of the current row can be read simultaneously, so that the logical information stored in the storage cells can be read row by row, thereby implementing quick reading of the plurality of storage cells in the storage array.

In a possible implementation, the first direction and the second direction are orthogonal.

In a possible implementation, the first thin film transistor further includes a first modulation gate electrode disposed between the first electrode and the second electrode, the first modulation gate electrode is disposed on a side of the semiconductor layer that is away from the gate body, and the first modulation gate electrode is surrounded by a first dielectric layer of the first thin film transistor, so as to be spaced from the second electrode, the first electrode, and the semiconductor layer; and first modulation gate electrodes of a plurality of first thin film transistors located at a same layer are electrically connected together; and/or the second thin film transistor further includes a second modulation gate electrode disposed between the first electrode and the second electrode, the second modulation gate electrode is disposed on a side of the semiconductor layer that is away from the gate body, and the second modulation gate electrode is surrounded by a first dielectric layer of the second thin film transistor, so as to be spaced from the second electrode, the first electrode, and the semiconductor layer; and second modulation gate electrodes of a plurality of second thin film transistors located at a same layer are electrically connected together. The first thin film transistor includes the first modulation gate electrode, so that a threshold voltage of the first thin film transistor may be adjusted by using the first modulation gate electrode. In addition, first modulation gate electrodes of a plurality of first thin film transistors are electrically connected together, so that joint modulation of the plurality of first thin film transistors may be implemented. The second thin film transistor includes the second modulation gate electrode, so that a threshold voltage of the second thin film transistor may be adjusted by using the second modulation gate electrode. In addition, second modulation gate electrodes of a plurality of second thin film transistors are electrically connected together, so that joint modulation of the plurality of second thin film transistors may be implemented. Based on this, storage performance of the memory can be adjusted more flexibly.

In a possible implementation, the memory further includes an integrated circuit, and the storage array is disposed on the integrated circuit. In this case, the memory is an on-chip memory.

In a possible implementation, the storage cell is electrically connected to the integrated circuit. In this way, the storage cell may be controlled by using the integrated circuit.

According to a third aspect, an electronic device is provided. The electronic device includes a circuit board and a memory electrically connected to the circuit board, and the memory is the foregoing memory. The electronic device has a same technical effect as that in the foregoing embodiments, and details are not described herein again.

According to a fourth aspect, a thin film transistor manufacturing method is provided. The thin film transistor manufacturing method includes: first, forming a first electrode, a first dielectric layer, a second electrode, and a semiconductor layer on a substrate, where the first electrode, the first dielectric layer, and the second electrode are sequentially stacked, the first dielectric layer separates the first electrode from the second electrode, the semiconductor layer is formed on a side surface of the first dielectric layer, and the second electrode and the first electrode are both electrically connected to the semiconductor layer; and then sequentially forming a second dielectric layer and a gate, where the gate includes a gate base located at a top portion and a gate body extending from the gate base to a bottom portion, and the second dielectric layer separates the gate from the semiconductor layer, the first electrode, and the second electrode. The thin film transistor manufacturing method has a same technical effect as that in the foregoing embodiments, and details are not described herein again.

In a possible implementation, the first electrode is formed as a drain, and the second electrode is formed as a source; or the first electrode is formed as a source, and the second electrode is formed as a drain.

In a possible implementation, the forming a first electrode, a first dielectric layer, a second electrode, and a semiconductor layer on a substrate includes: first, sequentially forming a first conductive thin film, a first dielectric thin film, and a second conductive thin film that are stacked on the substrate; then patterning the first conductive thin film, the first dielectric thin film, and the second conductive thin film to form the first electrode, the first dielectric layer, and the second electrode that are stacked sequentially; and then forming the semiconductor layer on the side surface of the first dielectric layer and a side surface of the second electrode.

In a possible implementation, the forming a first electrode, a first dielectric layer, a second electrode, and a semiconductor layer on a substrate includes: first, forming a first conductive thin film and a third dielectric thin film that are sequentially stacked on the substrate; then, forming a modulation gate electrode on the third dielectric thin film; then, forming a fourth dielectric thin film, where the fourth dielectric thin film surrounds the modulation gate electrode; then, forming a second conductive thin film on the fourth dielectric thin film; next, patterning the first conductive thin film to form the first electrode, patterning the fourth dielectric thin film and the third dielectric thin film to form the first dielectric layer, and patterning the second conductive thin film to form the second electrode; and forming the semiconductor layer on the side surface of the first dielectric layer and a side surface of the second electrode. A threshold voltage of the thin film transistor may be adjusted by using the modulation gate electrode.

In a possible implementation, the forming a first electrode, a first dielectric layer, a second electrode, and a semiconductor layer on a substrate includes: first, forming a first conductive thin film and a first dielectric thin film that are sequentially stacked on the substrate; then, patterning the first conductive thin film and the first dielectric thin film to form the first electrode and the first dielectric layer that are sequentially stacked; then, forming the semiconductor layer on the side surface of the first dielectric layer; and then, forming the second electrode on the first dielectric layer.

In a possible implementation, a material of the second dielectric layer is a ferroelectric material; and after the semiconductor layer is formed and before the second dielectric layer is formed, the manufacturing method further includes: forming a third dielectric layer, where the third dielectric layer is formed on the side surface of the first dielectric layer. The third dielectric layer has a same technical effect as that in the foregoing embodiments, and details are not described herein again.

In a possible implementation, after the third dielectric layer is formed and before the second dielectric layer is formed, the manufacturing method further includes: forming a first conductive layer, where the first conductive layer is formed on the side surface of the first dielectric layer. The first conductive layer has a same technical effect as that in the foregoing embodiments, and details are not described herein again.

In a possible implementation, after the first electrode is formed and before the semiconductor layer is formed, the manufacturing method further includes: forming a fifth dielectric layer, where the fifth dielectric layer is in contact with the first electrode and the semiconductor layer respectively. In this way, a problem of diffusion of the first electrode in a contact region with the semiconductor layer may be avoided, and a Fermi level pinning problem of contact between the first electrode and the semiconductor layer may be reduced.

In a possible implementation, after the second electrode is formed and before the semiconductor layer is formed; or after the semiconductor layer is formed and before the second electrode is formed, the manufacturing method further includes: forming a fourth dielectric layer, where the fourth dielectric layer is in contact with the second electrode and the semiconductor layer respectively. In this way, a problem of diffusion of the second electrode in a contact region with the semiconductor layer may be avoided, and a Fermi level pinning problem of contact between the second electrode and the semiconductor layer may be reduced.

According to a fifth aspect, a memory manufacturing method is provided. The memory manufacturing method includes forming at least one layer of storage array on a substrate A method for manufacturing any layer of storage array includes: first, forming, on the substrate, a plurality of first signal lines arranged in parallel; then, forming, on the plurality of first signal lines, a plurality of first thin film transistors distributed in an array and a plurality of second signal lines arranged in parallel, where the first thin film transistor is manufactured by using the foregoing thin film transistor manufacturing method, a first electrode of the first thin film transistor is electrically connected to the first signal line, and a second electrode of the first thin film transistor is electrically connected to the second signal line; and the first signal line is one of a read bit line and a read word line, and the second signal line is the other of the read bit line and the read word line; next, forming, on the first thin film transistors, a plurality of second thin film transistors distributed in an array and a plurality of write bit lines arranged in parallel, where a second electrode of the second thin film transistor is electrically connected to the write bit line, the second thin film transistor is manufactured by using the foregoing thin film transistor manufacturing method, one second thin film transistor corresponds to one first thin film transistor, and a first electrode of the second thin film transistor is electrically connected to a gate of the corresponding first thin film transistor; and next, forming, on the second thin film transistors, a plurality of write word lines arranged in parallel, where a gate of the second thin film transistor is electrically connected to the write word line. Both the first thin film transistor and the second thin film transistor in the memory are manufactured by using the foregoing thin film transistor manufacturing method, so that sizes of the first thin film transistor and the second thin film transistor in the manufactured memory are relatively small, thereby improving area utilization.

In a possible implementation, after the forming, on the plurality of first signal lines, a plurality of first thin film transistors distributed in an array and a plurality of second signal lines arranged in parallel, and before the forming, on the first thin film transistors, a plurality of second thin film transistors distributed in an array and a plurality of write bit lines arranged in parallel, the manufacturing method of any layer of storage array further includes: forming a plurality of connection electrodes distributed in an array, where a gate of the first thin film transistor is electrically connected to a first electrode of the corresponding second thin film transistor by using the connection electrode.

### BRIEF DESCRIPTION OF DRAWINGS

FIG. 1 is a schematic diagram of a structure of a thin film transistor in the prior art;
FIG. 2a is a schematic diagram of a structure of a storage cell in a memory of a 2T0C structure;
FIG. 2b is a schematic diagram of structures of a second thin film transistor and a first thin film transistor in a storage cell;
FIG. 2c is a schematic diagram of structures of a second thin film transistor and a first thin film transistor in another storage cell;
FIG. 3 is a schematic diagram of a structure of an electronic device according to an embodiment of this application;
FIG. 4 is a schematic diagram of a structure of a memory according to an embodiment of this application;
FIG. 5 is a schematic diagram of a structure of a storage array according to an embodiment of this application;
FIG. 6a is a schematic diagram of a structure of a storage array according to another embodiment of this application;
FIG. 6b is a schematic cross-sectional view along a first direction in FIG. 6a;
FIG. 6c is a schematic cross-sectional view along a second direction in FIG. 6a;
FIG. 6d is a schematic cross-sectional view along a direction AA in FIG. 6b or FIG. 6c;
FIG. 6e is another schematic cross-sectional view along a direction AA in FIG. 6b or FIG. 6c;
FIG. 7 is a schematic diagram of a structure of a memory according to another embodiment of this application;
FIG. 8a is a schematic diagram of a structure of a thin film transistor according to an embodiment of this application;
FIG. 8b is a schematic cross-sectional view along a direction BB in FIG. 8a;
FIG. 8c is another schematic cross-sectional view along a direction BB in FIG. 8a;
FIG. 9 is a schematic diagram of a structure of a thin film transistor according to another embodiment of this application;
FIG. 10 is a schematic diagram of a structure of a thin film transistor according to still another embodiment of this application;
FIG. 11 is a schematic diagram of a structure of a thin film transistor according to yet another embodiment of this application;
FIG. 12a is a schematic diagram of a structure of a thin film transistor according to another embodiment of this application;
FIG. 12b is a schematic diagram of a structure of a thin film transistor according to still another embodiment of this application;
FIG. 12c is a schematic diagram of a structure of a thin film transistor according to yet another embodiment of this application;
FIG. 13 is a schematic diagram of a structure of a thin film transistor according to another embodiment of this application;
FIG. 14 is a schematic diagram of a structure of a thin film transistor according to still another embodiment of this application;
FIG. 15 is a schematic diagram of a structure of a thin film transistor according to yet another embodiment of this application;
FIG. 16 is a schematic diagram of a structure of a thin film transistor according to another embodiment of this application;
FIG. 17a is a schematic diagram of a structure of a storage array according to still another embodiment of this application;
FIG. 17b is a schematic cross-sectional view along a direction CC in FIG. 17a;
FIG. 17c is another schematic cross-sectional view along a direction CC in FIG. 17a;
FIG. 18 is a schematic flowchart of a thin film transistor preparation method according to an embodiment of this application;
FIG. 19 is a schematic diagram of structures of a thin film transistor preparation process according to an embodiment of this application;
FIG. 20 is a schematic diagram of structures of another thin film transistor preparation process according to an embodiment of this application;
FIG. 21 is a schematic diagram of structures of still another thin film transistor preparation process according to an embodiment of this application;
FIG. 22 is a schematic diagram of structures of still another thin film transistor preparation process according to an embodiment of this application;
FIG. 23 is a schematic diagram of structures of still another thin film transistor preparation process according to an embodiment of this application;
FIG. 24 is a schematic diagram of structures of still another thin film transistor preparation process according to an embodiment of this application;
FIG. 25 is a schematic diagram of structures of still another thin film transistor preparation process according to an embodiment of this application;
FIG. 26 is a schematic diagram of structures of still another thin film transistor preparation process according to an embodiment of this application;
FIG. 27 is a schematic diagram of structures of still another thin film transistor preparation process according to an embodiment of this application;
FIG. 28 is a schematic diagram of structures of still another thin film transistor preparation process according to an embodiment of this application;
FIG. 29 is a schematic diagram of structures of still another thin film transistor preparation process according to an embodiment of this application; and
FIG. 30 is a schematic flowchart of a memory preparation method according to an embodiment of this application.

### Reference numerals:

1-Antenna; 2-Antenna; 10-Thin film transistor; 100-Electronic device; 101-Substrate; 102-Semiconductor layer; 103-Source; 104-Drain; 105-Gate insulation layer; 106-Gate; 107-Interlayer dielectric layer; 108-Second electrode; 109-First electrode; 110-Processor; 111-Connection electrode; 112-Second dielectric layer; 113-First dielectric layer; 114-Fourth dielectric layer; 115-Fifth dielectric layer; 116-Third dielectric layer; 117-First conductive layer; 118-Modulation gate electrode; 118a-First modulation gate electrode; 118b-Second modulation gate electrode; 120-External memory interface; 121-Internal memory; 130-USB interface; 140-Charging management module; 141-Power management module; 142-Battery; 150-Mobile communication module; 160-Wireless communication module; 170-Audio module; 180-Sensor module; 190-Button; 191-Motor; 192-Indicator; 193-Camera; 194-Display screen; 195-SIM card interface; 200-Memory; 201-Storage array; 201A-Storage cell; 202-Sixth dielectric layer; 203-Integrated circuit; 1080-Second conductive thin film; 1090-First conductive thin film; 1121-First dielectric part; 1122-Second dielectric part; 1130-First dielectric thin film; 1131-Third dielectric thin film; and 1132-Fourth dielectric thin film.

### DESCRIPTION OF EMBODIMENTS

The following describes the technical solutions in embodiments of this application with reference to the accompanying drawings in embodiments of this application. It is clear that the described embodiments are merely some rather than all of embodiments of this application.

The following terms "first", "second" and the like are merely intended for ease of description, and shall not be understood as an indication or implication of relative importance or implicit indication of a quantity of indicated technical features. Therefore, a feature limited by "first", "second", or the like may explicitly or implicitly include one or more of the features. In the descriptions of this application, unless otherwise stated, "a plurality of" means two or more than two.

In embodiments of this application, unless otherwise clearly specified and limited, the term "connection" should be understood in a broad sense. For example, the "connection" may be a fixed connection, a detachable connection, or an integral connection; or may be a direct connection, or may be an indirect connection through an intermediate medium. In addition, the term "electrical connection" may be a direct electrical connection, or may be an indirect electrical connection through an intermediate medium. In addition, the term "coupling" may indicate that two or more components are in direct physical contact or electrical contact, or may indicate that two or more components are not in direct contact with each other, but are electrically connected or interact with each other through an intermediate medium.

In embodiments of this application, the word "example" or "for example" or the like is used to represent giving an example, an illustration, or a description. Any embodiment or design solution described as an "example" or "for example" in embodiments of this application should not be explained as being more preferred or having more advantages than another embodiment or design solution. Exactly, use of the word "example", "for example" or the like is intended to present a relative concept in a specific manner.

In embodiments of this application, the term "and/or" describes an association relationship between associated objects and may indicate that three relationships exist. For example, A and/or B may indicate the following cases: Only A exists, both A and B exist, and only B exists, where A and B may be singular or plural. The character "/" generally indicates an "or" relationship between the associated objects.

In embodiments of this application, descriptions about the accompanying drawings are descriptions based on directions shown in the accompanying drawings. When the directions shown in the accompanying drawings change, corresponding descriptions also change accordingly.

With the continuous development of integrated circuit technologies, a quantity of transistors disposed on a chip per unit area in an electronic product such as a computer or a mobile phone continuously increases, so that performance of the electronic product is continuously optimized. On one hand, an amount of data that can be operated by a processor on the chip in a unit time continuously increases; and on the other hand, a storage density of a memory on the chip also continuously increases, thereby meeting people's requirements for data processing in the information era. However, because a logical unit in the processor and a storage cell in the memory are different in structures and techniques, performance improvement degrees of the processor and the memory are different. Specifically, the storage density and a read/write speed of the memory cannot keep up with an operation speed of the processor, and a "storage wall" appears, which finally limits overall performance improvement of the electronic product.

To resolve the foregoing problem, various types of memories emerge. In various types of memories, a gain cell (gain cell) memory is widely used, and a main target application scenario of the gain cell memory is a high-speed and high-density memory. A gain cell memory of a 2T0C structure can implement a nanosecond-level read/write speed and a millisecond-level storage time. The storage time refers to a time for keeping information stored in the memory, that is, a time from a time when the information is written to a time when the information is correctly read. However, a storage time of the gain cell memory of the 2T0C structure is relatively short, the gain cell memory of the 2T0C structure needs to be continuously refreshed in an actual application. This causes relatively large dynamic power consumption.

Based on the foregoing description, to improve keeping duration of the memory of the 2T0C structure and resolve a problem that power consumption of the gain cell memory of the 2T0C structure is relatively large, currently, the gain cell memory of the 2T0C structure may be prepared based on a TFT. On one hand, an advantage of an ultra-low leakage current of the TFT may be used, so that a keeping time of the memory of the 2T0C structure is greatly increased, and dynamic power consumption is reduced; and on the other hand, an advantage of a low temperature of a TFT manufacturing process may be used, so as to implement three-dimensional (three-dimensional, 3D) memory integration, and improve a storage density.

Refer to FIG. 2a, FIG. 2a is a schematic diagram of a structure of a storage cell in a memory of a 2T0C structure. The storage cell includes a first thin film transistor Tr0 and a second thin film transistor Tr1. A gate of the second thin film transistor Tr1 is electrically connected to a write word line WWL, a source of the second thin film transistor Tr1 is electrically connected to a write bit line WBL, a drain of the second thin film transistor Tr1 is electrically connected to a gate of the first thin film transistor Tr0, a source of the first thin film transistor Tr0 is electrically connected to a read word line RWL, and a drain of the first thin film transistor Tr0 is electrically connected to a read bit line RBL.

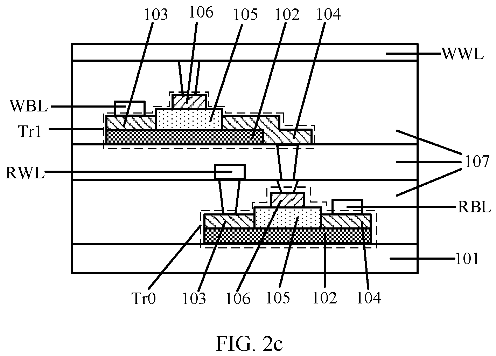

FIG. 2b and FIG. 2c are respectively schematic diagrams of structures of a first thin film transistor Tr0 and a second thin film transistor Tr1 in a storage cell of a TFT-based memory of a 2T0C structure. Refer to FIG. 2b and FIG. 2c, both the first thin film transistor Tr0 and the second thin film transistor Tr1 include a semiconductor layer 102 disposed on a substrate 101, a source 103 and a drain 104 that are disposed on the semiconductor layer 102 and in contact with the semiconductor layer 102, a gate insulation layer 105 disposed on the semiconductor layer 102, and a gate 106 disposed on the gate insulation layer 105. In addition, an interlayer dielectric layer 107 in FIG. 2b and FIG. 2c is configured to space different conductive film layers, and a signal line is electrically connected to a corresponding electrode by using a via. For example, a read word line RWL is electrically connected to the source 103 of the first thin film transistor Tr0 by using a via.

However, because the semiconductor layers 102 in the first thin film transistor Tr0 and the second thin film transistor Tr1 shown in FIG. 2b and FIG. 2c are both spread along a plane parallel to the gate 106, and the source 103 and the drain 104 are disposed at a same layer. In this way, sizes of the first thin film transistor Tr0 and the second thin film transistor Tr1 are relatively large, and area utilization of the first thin film transistor Tr0 and the second thin film transistor Tr1 is low. In addition, because the source 103 and the drain 104 are located at a same layer, a short circuit easily occurs on a signal line electrically connected to the source electrode 103 and a signal line electrically connected to the drain electrode 104, which is not conducive to routing and increases process difficulty.

To resolve the foregoing problem, an embodiment of this application provides a memory. The memory may be used in an electronic device. The electronic device may be a mobile phone, a tablet computer, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a wearable device, an invehicle device, a smart home device, and/or a smart city device, and a specific type of the electronic device is not specifically limited in embodiments of this application.

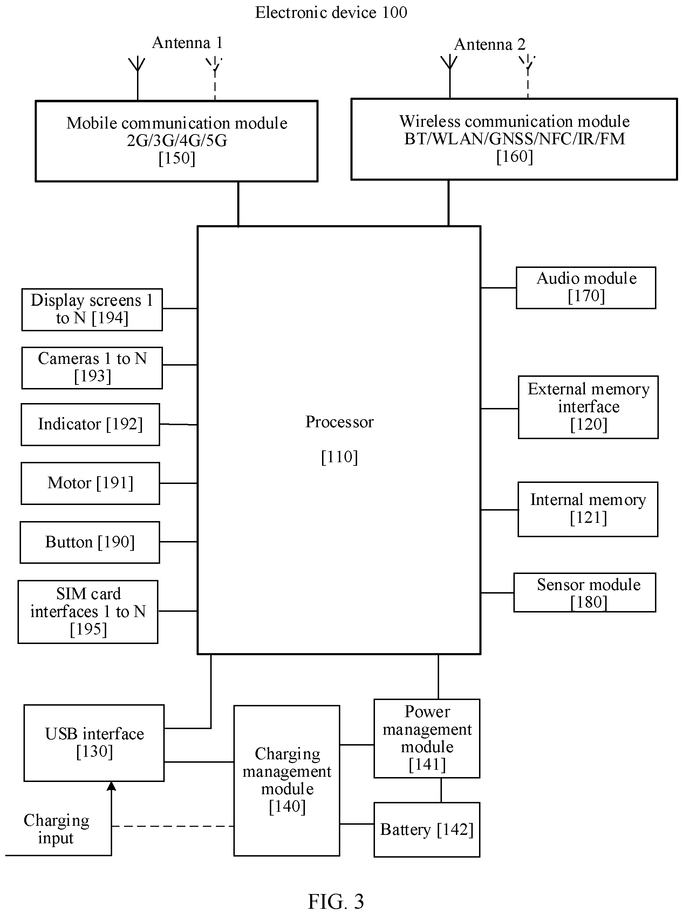

FIG. 3 is a schematic diagram of a structure of an electronic device. The electronic device 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a sensor module 180, a button 190, a motor 191, an indicator 192, a camera 193, a display screen 194, and a subscriber identity module (subscriber identity module, SIM) card interface 195.

It may be understood that the structure shown in this embodiment of this application does not constitute a specific limitation on the electronic device 100. In some other embodiments of this application, the electronic device 100 may include more or fewer components than those shown in the figure, or some components may be combined, or some components may be split, or different component deployments may be used. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent components, or may be integrated into one or more processors.

The controller may generate an operation control signal based on an instruction operation code and a time sequence signal, to complete control of instruction reading and instruction execution.

A memory may be further disposed in the processor 110, and is configured to store instructions and data. In some embodiments, the memory in the processor 110 is a cache memory. The memory may store instructions or data that has just been used or cyclically used by the processor 110. If the processor 110 needs to use the instructions or the data again, the processor may directly invoke the instructions or the data from the memory. This avoids repeated access, reduces a waiting time of the processor 110, and therefore improves system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, and/or a universal serial bus (universal serial bus, USB) interface.

The I2C interface is a two-way synchronization serial bus, and includes a serial data line (serial data line, SDA) and a serial clock line (serial clock line, SCL). The I2S interface may be configured to perform audio communication.

The PCM interface may also be configured to perform audio communication, and sample, quantize, and code an analog signal.

The UART interface is a universal serial data bus, and is configured to perform asynchronous communication. The bus may be a two-way communication bus. The UART interface converts to-be-transmitted data between serial communication and parallel communication.

The MIPI interface may be configured to connect the processor 110 to a peripheral component such as the display screen 194 or the camera 193. The MIPI interface includes a camera serial interface (camera serial interface, CSI), a display serial interface (display serial interface, DSI), and the like.

The GPIO interface may be configured by software. The GPIO interface may be configured as a control signal or a data signal. The GPIO interface may alternatively be configured as an I2C interface, an I2S interface, a UART interface, or an MIPI interface.

The USB interface 130 is an interface that conforms to a USB standard specification, and may be specifically a Mini USB interface, a Micro USB interface, or a USB Type-C interface. The USB interface 130 may be configured to connect to a charger to charge the electronic device 100, or may be configured to transmit data between the electronic device 100 and a peripheral device, or may be configured to connect to a headset, to play audio by using the headset.

It may be understood that an interface connection relationship between the modules that are shown in this embodiment of the present invention is merely an example for description, and does not constitute a limitation on a structure of the electronic device 100. In some other embodiments of this application, the electronic device 100 may alternatively use an interface connection manner different from that in the foregoing embodiment, or use a combination of a plurality of interface connection manners.

The charging management module 140 is configured to receive a charging input from a charger. The charger may be a wireless charger or a wired charger.

The power management module 141 is configured to connect to the battery 142, the charging management module 140, and the processor 110. The power management module 141 receives an input from the battery 142 and/or the charging management module 140, and supplies power to the processor 110, the internal memory 121, the display screen 194, the camera 193, and the wireless communication module 160. The power management module 141 may be further configured to monitor parameters such as a battery capacity, a battery cycle count, and a battery state of health (electric leakage or impedance). In some other embodiments, the power management module 141 may alternatively be disposed in the processor 110. In some other embodiments, the power management module 141 and the charging management module 140 may alternatively be disposed in a same component.

A wireless communication function of the electronic device 100 may be implemented by using the antenna 1, the antenna 2, the mobile communication module 150, the wireless communication module 160, the modem processor, and the baseband processor.

The antenna 1 and the antenna 2 are configured to transmit and receive an electromagnetic wave signal. Each antenna in the electronic device 100 may be configured to cover one or more communication frequency bands. Different antennas may be further multiplexed, to improve antenna utilization. For example, the antenna 1 may be multiplexed as a diversity antenna of a wireless local area network. In some other embodiments, the antenna may be used in combination with a tuning switch.

The mobile communication module 150 may provide a wireless communication solution that includes 2G/3G/4G/5G and that is applied to the electronic device 100. The mobile communication module 150 may include at least one filter, a switch, a power amplifier, and a low noise amplifier (low noise amplifier, LNA). The mobile communication module 150 may receive an electromagnetic wave through the antenna 1, perform processing such as filtering or amplification on the received electromagnetic wave, and transmit the electromagnetic wave to the modem processor for demodulation. The mobile communication module 150 may further amplify a signal modulated by the modem processor, and convert the signal into an electromagnetic wave for radiation through the antenna 1.

The modem processor may include a modulator and a demodulator. The modulator is configured to modulate a to-be-sent low-frequency baseband signal into a medium-high-frequency signal. The demodulator is configured to demodulate a received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal by using an audio device (which is not limited to a loudspeaker or a telephone receiver), or displays an image or a video by using the display screen 194.

The wireless communication module 160 may provide a wireless communication solution that is applied to the electronic device 100, and that includes a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, or an infrared (infrared, IR) technology. The wireless communication module 160 may be one or more components integrating at least one communication processor module. The wireless communication module 160 receives an electromagnetic wave through the antenna 2, performs frequency modulation and filtering processing on an electromagnetic wave signal, and sends a processed signal to the processor 110. The wireless communication module 160 may further receive a to-be-sent signal from the processor 110, perform frequency modulation and amplification on the signal, and convert the signal into an electromagnetic wave for radiation through the antenna 2.

In some embodiments, the antenna 1 of the electronic device 100 is electrically connected to the mobile communication module 150, and the antenna 2 is electrically connected to the wireless communication module 160, so that the electronic device 100 can communicate with a network and another device by using a wireless communication technology. The wireless communication technology may include a global system for mobile communications (global system for mobile communications, GSM), a general packet radio service (general packet radio service, GPRS), and code division multiple access (code division multiple access, CDMA).

The electronic device 100 may implement a display function through the GPU, the display screen 194, and the application processor. The GPU is a microprocessor for image processing, and is connected to the display screen 194 and the application processor. The GPU is configured to perform mathematical and geometric computation and render an image. The processor 110 may include one or more GPUs, which execute program instructions to generate or change display information.

The display screen 194 is configured to display an image or a video. In some embodiments, the electronic device 100 may include one or N display screens 194, where N is a positive integer greater than 1.

The electronic device 100 may implement a photographing function through the ISP, the camera 193, the video codec, the GPU, the display screen 194, and the application processor.

The ISP is configured to process data fed back by the camera 193.

The camera 193 is configured to capture a static image or a video. In some embodiments, the electronic device 100 may include one or N cameras 193, where N is a positive integer greater than 1.

The external memory interface 120 may be configured to connect to an external storage card, for example, a Micro SD card, to extend a storage capability of the electronic device 100. The external storage card communicates with the processor 110 through the external memory interface 120, to implement a data storage function. For example, files such as music and videos are stored in the external storage card.

The internal memory 121 may be configured to store computer-executable program code. The executable program code includes instructions. The internal memory 121 may include a program storage region and a data storage region. The program storage region may store an operating system and an application program required by at least one function (for example, a sound playback function or an image display function). The data storage region may store data (such as audio data and an address book) created during use of the electronic device 100. In addition, the internal memory 121 may include a high-speed random access memory, or may include a non-volatile memory, for example, at least one magnetic disk storage device, a flash memory device, or a universal flash storage (universal flash storage, UFS). The processor 110 runs the instructions stored in the internal memory 121 and/or the instructions stored in the memory disposed in the processor, to perform various function applications and data processing of the electronic device 100.

The electronic device 100 may implement an audio function by using the audio module 170 and the application processor, for example, music playback and recording.

The audio module 170 is configured to convert digital audio information into an analog audio signal for output, and is also configured to convert an analog audio input into a digital audio signal. The audio module 170 may be further configured to code and decode an audio signal.

The button 190 includes a power button, a volume button, and the like. The button 190 may be a mechanical button, or may be a touch button. The electronic device 100 may receive a button input, and generate a button signal input related to a user setting and function control of the electronic device 100.

The motor 191 may generate a vibration prompt. The motor 191 may be configured to provide an incoming call vibration prompt and a touch vibration feedback.

The indicator 192 may be an indicator light, and may be configured to indicate a charging status and a power change, or may be configured to indicate a message, a missed call, and a notification.

The SIM card interface 195 is configured to connect to a SIM card. The SIM card may be inserted into the SIM card interface 195 or removed from the SIM card interface 195, to implement contact with or separation from the electronic device 100. The electronic device 100 may support one or N SIM card interfaces, where N is a positive integer greater than 1.

Based on this, the electronic device 100 may further include a circuit board, for example, a printed circuit board (printed circuit board, PCB). The processor 110 and the internal memory 121 may be disposed on the circuit board, and the processor 110 and the internal memory 121 are electrically connected to the circuit board.

The memory provided in this embodiment of this application may be used as the internal memory 121 in the electronic device 100, or may be used as the memory in the processor 110 of the electronic device 100.

The memory provided in this embodiment of this application may be an off-chip memory, or may be an on-chip memory (which may also be referred to as an embedded memory).

In addition, the memory provided in this embodiment of this application may be a memory prepared based on a back end of line (back end of line, BEOL) process.

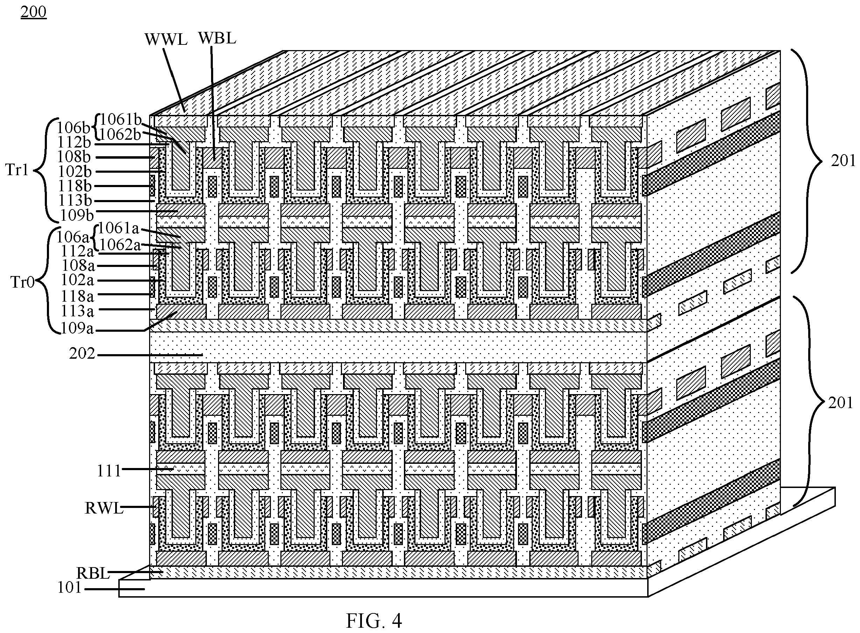

Refer to FIG. 4, the memory 200 includes at least one layer of storage array 201 disposed on a substrate 101. FIG. 4 is a schematic diagram by using an example in which the memory 200 includes two layers of storage arrays 201. In a case that the memory 200 includes a plurality of layers of storage arrays 201, as shown in FIG. 4, the storage arrays 201 may be sequentially stacked along a vertical direction.

In addition, in a case that the memory 200 includes a plurality of layers of storage arrays 201, the memory 200 may also be referred to as a three-dimensional integrated memory.

In addition, a quantity of layers of the storage arrays 201 may be stacked as required. A larger quantity of layers of the stacked storage arrays 201 indicates a higher storage density of the memory 200.

In a case that the memory 200 includes a plurality of layers of storage arrays 201, in some embodiments, refer to FIG. 4, the memory 200 further includes a sixth dielectric layer 202 disposed between two adjacent layers of storage arrays 201, and the two adjacent layers of storage arrays 201 are separated by using the sixth dielectric layer 202.

A material of the sixth dielectric layer 202 may be one or more of an insulation material such as SiO₂ (silicon dioxide), Al₂O₃ (aluminum oxide), HfO₂ (hafnium dioxide), ZrOz (zirconium oxide), TiO₂ (titanium dioxide), Y₂O₃ (yttrium trioxide), and Si₃N₄ (silicon nitride).

The sixth dielectric layer 202 may be a single-layer structure, or may be a multi-layer stacked structure. In addition, a material of the single-layer structure and a material of each layer in the multi-layer stacked structure may be one or more of SiO₂, Al₂O₃, HfO₂, ZrO₂, TiO₂, Y₂O₃, and Si₃N₄.

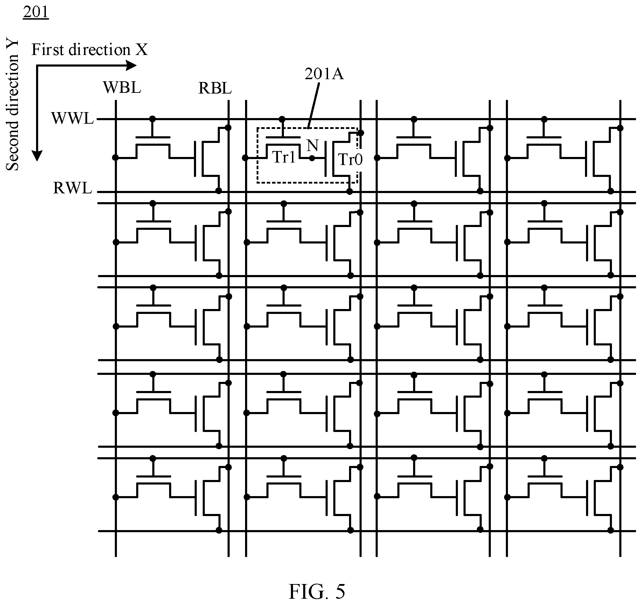

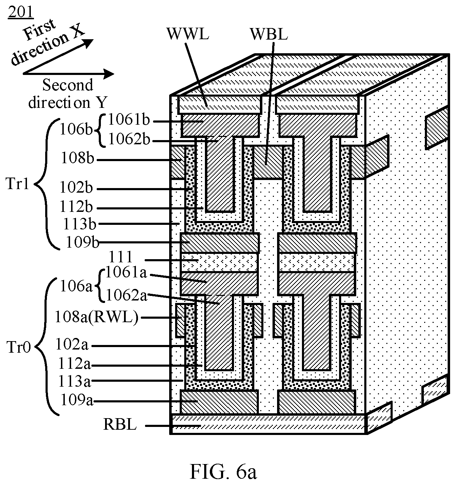

Refer to FIG. 5 and FIG. 6a, each layer of storage array 201 includes a plurality of storage cells 201A, write word lines WWLs (write word lines), write bit lines WBLs (write bit lines), read word lines RWLs (read word lines), and read bit lines RBLs (read bit lines) that are distributed in an array.

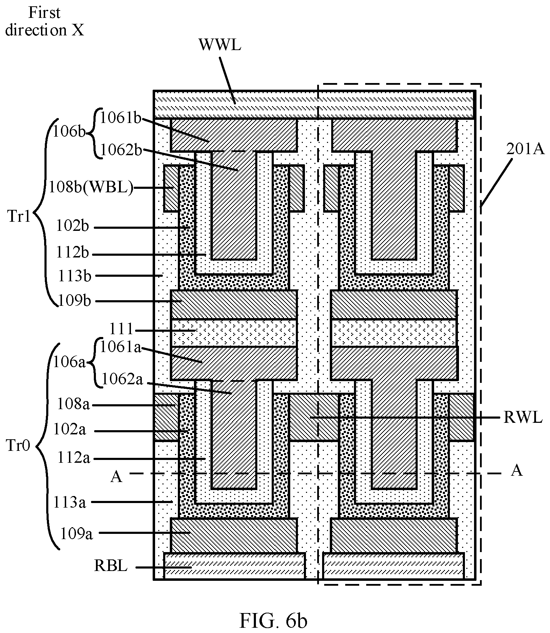

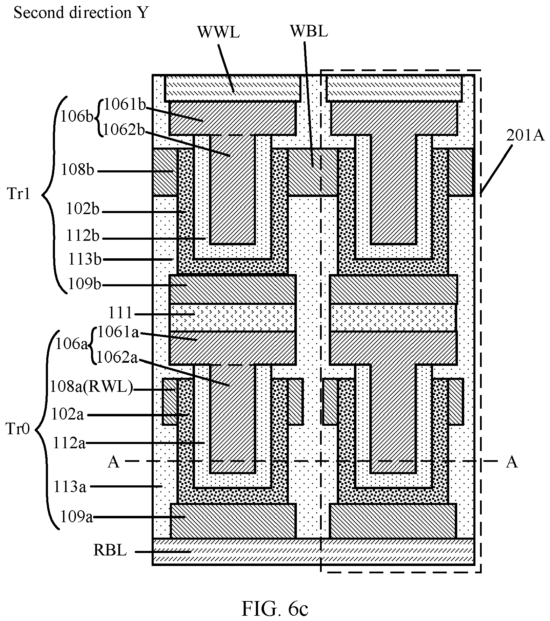

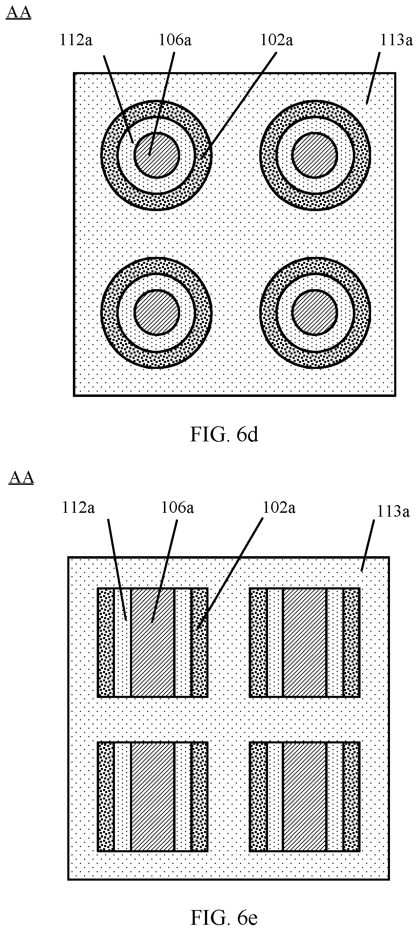

Refer to FIG. 6a, FIG. 6b, FIG. 6c, FIG. 6d, and FIG. 6e, the storage cell 201A includes a first thin film transistor Tr0 and a second thin film transistor Tr1 that are stacked.

The first thin film transistor Tr0 includes a gate 106a, and the gate 106a includes a gate base 1061a located at a top portion and a gate body 1062a extending from the gate base 1061a to a bottom portion. The first thin film transistor Tr0 further includes a first electrode 109a, a second electrode 108a, a first dielectric layer 113a, a second dielectric layer 112a, and a semiconductor layer 102a. The first electrode 109a is located at the bottom portion, and the second electrode 108a is located between the first electrode 109a and the gate base 1061a. The first dielectric layer 113a is disposed between the second electrode 108a and the first electrode 109a, and the first dielectric layer 113a is configured to separate the first electrode 109a from the second electrode 108a. The semiconductor layer 102a is disposed along a side surface of the gate body 1062a, and the second dielectric layer 112a separates the semiconductor layer 102a from the gate 106a. The first electrode 109a and the second electrode 108a are electrically connected to the semiconductor layer 102a respectively.

As shown in FIG. 6a, FIG. 6b, FIG. 6c, and FIG. 6d, the second dielectric layer 112a covers a surface of the gate base 1061a and a surface of the gate body 1062a. Further, the second dielectric layer 112a surrounds an outer side of the gate body 1062a on the first electrode 109a, the semiconductor layer 102a surrounds an outer side of the second dielectric layer 112a, and the second electrode 108a is disposed on an outer side of the semiconductor layer 102a and is electrically connected to the semiconductor layer 102a. The second electrode 108a is on the first electrode 109a and is separated by the first dielectric layer 113a, and the first electrode 109a is electrically connected to the semiconductor layer 102a.

The second thin film transistor Tr1 includes a gate 106b, and the gate 106b includes a gate base 1061b located at a top portion and a gate body 1062b extending from the gate base 1061b to a bottom portion. The second thin film transistor Tr1 further includes a first electrode 109b, a second electrode 108b, a first dielectric layer 113b, a second dielectric layer 112b, and a semiconductor layer 102b. The first electrode 109b is located at the bottom portion, and the second electrode 108b is located between the first electrode 109a and the gate base 1061a. The first dielectric layer 113b is disposed between the second electrode 108b and the first electrode 109b, and the first dielectric layer 113b is configured to separate the first electrode 109b from the second electrode 108b. The second dielectric layer 112b covers a surface of the gate base 1061b and a surface of the gate body 1062b. The semiconductor layer 102b is disposed along a side surface of the gate body 1062b, and the second dielectric layer 112b separates the semiconductor layer 102b from the gate 106b. The first electrode 109b and the second electrode 108b are electrically connected to the semiconductor layer 102b respectively.

As shown in FIG. 6a, FIG. 6b, FIG. 6c, and FIG. 6d, the second dielectric layer 112b surrounds an outer side of the gate body 1062b on the first electrode 109b, the semiconductor layer 102b surrounds an outer side of the second dielectric layer 112b, and the second electrode 108b is disposed on an outer side the semiconductor layer 102b and is electrically connected to the semiconductor layer 102b. The second electrode 108b is on the first electrode 109b and is separated by the first dielectric layer 113b, and the first electrode 109b is electrically connected to the semiconductor layer 102b.

The gate 106b (gate, G) of the second thin film transistor Tr1 is electrically connected to a write word line WWL, and the second electrode 108b is electrically connected to a write bit line WBL. The first electrode 109a and the second electrode 108a of the first thin film transistor Tr0 are electrically connected to a read word line RWL and a read bit line RBL respectively. The first electrode 109b of the second thin film transistor Tr1 is close to the gate 106a of the first thin film transistor Tr0, and the first electrode 109b of the second thin film transistor Tr1 is electrically connected to the gate 106a of the first thin film transistor Tr0.

FIG. 6b is a schematic cross-sectional view along a first direction X in FIG. 6a; FIG. 6c is a schematic cross-sectional view along a second direction Y in FIG. 6a; FIG. 6d is a schematic cross-sectional view along a direction AA in FIG. 6b or FIG. 6c; and FIG. 6e is another schematic cross-sectional view along a direction AA in FIG. 6b or FIG. 6c.

It may be understood that the memory 200 provided in this embodiment of this application is a memory of a gain cell structure based on a 2T0C structure.

In some embodiments, the first electrode 109b of the second thin film transistor Tr1 is in direct contact with the gate 106a of the first thin film transistor Tr0. In some other embodiments, refer to FIG. 6a, FIG. 6b, and FIG. 6c, both the first electrode 109b of the second thin film transistor Tr1 and the gate 106a of the first thin film transistor Tr0 are in contact with a connection electrode 111, and the first electrode 109b of the second thin film transistor Tr1 is electrically connected to the gate 106a of the first thin film transistor Tr0 by using the connection electrode 111.

It should be noted that the second thin film transistor Tr1 is a write transistor, and the first thin film transistor Tr0 is a read transistor.

Structures of the second thin film transistor Tr1 and the first thin film transistor Tr0 may be the same or may be different. It should be understood that, in some embodiments, a projection of the second thin film transistor Tr1 on the substrate overlaps a projection of the first thin film transistor Tr0 on the substrate.

It should be understood that the write word line WWL may be manufactured synchronously with the gate 106b of the second thin film transistor Tr1, and the write bit line WBL may be manufactured synchronously with the second electrode 108b of the second thin film transistor Tr1.

The second electrode 108a of the first thin film transistor Tr0 may be electrically connected to the read word line RWL, and the first electrode 109a may be electrically connected to the read bit line RBL. In this case, the second electrode 108a of the first thin film transistor Tr0 and the read word line RWL may be synchronously manufactured, and the first electrode 109a of the first thin film transistor Tr0 and the read bit line RBL may be synchronously manufactured. Alternatively, the second electrode 108a of the first thin film transistor Tr0 may be electrically connected to the read bit line RBL, and the first electrode 109a may be electrically connected to the read word line RWL. In this case, the second electrode 108a of the first thin film transistor Tr0 and the read bit line RBL may be synchronously manufactured, and the first electrode 109a of the first thin film transistor Tr0 and the read word line RWL may be synchronously manufactured.

In this embodiment of this application, for the first thin film transistor Tr0, the second electrode 108a may be a source (source, S) 103, and the first electrode 109a may be a drain (drain, D) 104; or the second electrode 108a may be a drain 104, and the first electrode 109a may be a source 103. For the second thin film transistor Tr1, the second electrode 108b may be a source 103, and the first electrode 109b may be a drain 104; or the second electrode 108b may be a drain 104, and the first electrode 109b may be a source 103.

In addition, both the first thin film transistor Tr0 and the second thin film transistor Tr1 may be N-type transistors or may be P-type transistors. Certainly, one of the first thin film transistor Tr0 and the second thin film transistor Tr1 may be an N-type transistor, and the other may be a P-type transistor.

In some embodiments, a plurality of first thin film transistors Tr0 included in each layer of storage array 201 may be synchronously manufactured, and/or a plurality of second thin film transistors Tr1 included in each layer of storage array 201 may be synchronously manufactured.

Refer to FIG. 5, the following describes a write operation process and a read operation process of the memory 200 by using one storage cell 201A as an example.

Write operation process: In a write operation process, voltages on the read word line RWL and the read bit line RBL are 0, and the first thin film transistor Tr0 does not work; and the write word line WWL provides a first switch signal, and the first switch signal controls the second thin film transistor Tr1 to be turned on. When first logical information is written, and the first logical information is, for example, "0", the write bit line WBL provides a first level signal, and the first level signal is written into a node N by using the second thin film transistor Tr1, where the first level signal may control the first thin film transistor Tr0 to be turned on. When second logical information is written, and the second logical information is, for example, "1", the write bit line WBL provides a second level signal, and the second level signal is written into the node N by using the second thin film transistor Tr1, where the second level signal may control the first thin film transistor Tr0 to be turned off.

It should be understood that, after the write operation is completed, voltages on the read word line RWL and the read bit line RBL are 0, and the first thin film transistor Tr0 does not work; and the write word line WWL provides a second switch signal, and the second switch signal controls the second thin film transistor Tr1 to be turned off. In this case, a potential stored by the node N is not affected by an external environment.

Read operation process: The write word line WWL provides the second switch signal, and the second switch signal controls the second thin film transistor Tr1 to be turned off; and the read word line RWL provides a third level signal, and logical information stored in the storage cell 201A is determined based on a current on the read bit line RBL. When the node N stores the first level signal, because the first level signal may control the first thin film transistor Tr0 to be turned on, when the read word line RWL provides the third level signal, the read word line RWL charges the read bit line RBL by using the first thin film transistor Tr0, and the voltage on the read bit line RBL increases. In this way, when it is detected that the current on the read bit line RBL is relatively large, the logical information "0" stored in the storage cell 201A may be read. When the node N stores the second level signal, because the second level signal may control the first thin film transistor Tr0 to be turned off, when the read word line RWL provides the third level signal, the read word line RWL does not charge the read bit line RBL by using the first thin film transistor Tr0, and the read bit line RBL maintains a 0 V voltage. In this way, when it is detected that the current on the read bit line RBL is relatively small, the logical information "1" stored in the storage cell 201A may be read.

For a plurality of second thin film transistors Tr1, in some embodiments, refer to FIG. 5, FIG. 6a, and FIG. 6b, gates 106b of second thin film transistors Tr1 in a plurality of storage cells 201A that are sequentially arranged in each layer of storage array 201 along the first direction X are electrically connected to a same write word line WWL; and refer to FIG. 5, FIG. 6a, and FIG. 6c, second electrodes 108b of second thin film transistors Tr1 in a plurality of storage cells 201A that are sequentially arranged in each layer of storage array 201A along the second direction Y are electrically connected to a same write bit line WBL, where the first direction X intersects with the second direction Y

In some examples, the first direction X and the second direction Y are orthogonal. For ease of description, the following uses an example in which the first direction X is a row direction and the second direction Y is a column direction.

In each layer of storage array 201, the gates 106b of the second thin film transistors Tr1 in the plurality of storage cells 201A that are sequentially arranged along the first direction X are electrically connected to a same write word line WWL, and the second electrodes 108b of the second thin film transistors Tr1 in the plurality of storage cells 201A that are sequentially arranged along the second direction Y are electrically connected to a same write bit line WBL. Therefore, in the write operation process, the first switch signal may be provided to the plurality of write word lines WWL row by row, so that the plurality of rows of second thin film transistors Tr1 are turned on row by row. In a case that the first switch signal is provided to a write word line WWL of a current row, logical information is simultaneously written, by using a plurality of write bit lines WBL, to a plurality of storage cells 201A that are electrically connected to the write word line WWL of the current row, so that the logical information may be written to the storage cells 201A row by row, thereby implementing quick writing of the plurality of storage cells 201A in the storage array 201.

For example, a plurality of first thin film transistors Tr0 may be connected in the following four manners.

In a case that the first electrode 109a of the first thin film transistor Tr0 is electrically connected to the read bit line RBL, and the second electrode 108a is electrically connected to the read word line RWL, the following first manner or second manner may be used.

First manner: Refer to FIG. 5, FIG. 6a, and FIG. 6b, second electrodes 108a of first thin film transistors Tr0 in the plurality of storage cells 201A that are sequentially arranged in each layer of storage array 201 along the first direction X are electrically connected to a same read word line RWL; and refer to FIG. 5, FIG. 6a, and FIG. 6c, first electrodes 109a of first thin film transistors Tr0 in the plurality of storage cells 201A that are sequentially arranged in each layer of storage array 201 along the second direction Y are electrically connected to a same read bit line RBL, where the first direction X intersects with the second direction Y

In each layer of storage array 201, the second electrodes 108a of the first thin film transistors Tr0 in the plurality of storage cells 201A that are sequentially along the first direction X are electrically connected to a same read word line RWL, and the first electrodes 109a of the first thin film transistors Tr0 in the plurality of storage cells 201A that are sequentially arranged along the second direction Y are electrically connected to a same read bit line RBL. Therefore, in the read operation process, the third level signal may be provided to the plurality of read word lines RWL row by row. In a case that the third level signal is provided to a read word line RWL of a current row, a current on each read bit line RBL is detected. In this way, logical information stored in a plurality of storage cells 201A that are electrically connected to the read word line RWL of the current row can be simultaneously read, so that the logical information stored in the storage cells 201A can be read row by row, thereby implementing quick reading of the plurality of storage cells 201A in the storage array 201.

Second manner: Second electrodes 108a of first thin film transistors Tr0 in the plurality of storage cells 201A that are sequentially arranged in each layer of storage array 201 along the second direction Y are electrically connected to a same read word line RWL, and first electrodes 109a of first thin film transistors Tr0 in the plurality of storage cells 201A that are sequentially arranged in each layer of storage array 201 along the first direction X are electrically connected to a same read bit line RBL, where the first direction X intersects with the second direction Y

In a case that the first electrode 109a of the first thin film transistor Tr0 is electrically connected to the read word line RWL, and the second electrode 108a is electrically connected to the read bit line RBL, the following third manner or fourth manner may be used.

Third manner: Second electrodes 108a of first thin film transistors Tr0 in the plurality of storage cells 201A that are sequentially arranged in each layer of storage array 201 along the first direction X are electrically connected to a same read bit line RWL; and first electrodes 109a of first thin film transistors Tr0 in the plurality of storage cells 201A that are sequentially arranged in each layer of storage array 201 along the second direction Y are electrically connected to a same read word line RWL, where the first direction X intersects with the second direction Y

Fourth manner: Second electrodes 108a of first thin film transistors Tr0 in the plurality of storage cells 201A that are sequentially arranged in each layer of storage array 201 along the second direction Y are electrically connected to a same read bit line RWL; and first electrodes 109a of first thin film transistors Tr0 in the plurality of storage cells 201A that are sequentially arranged in each layer of storage array 201 along the first direction X are electrically connected to a same read word line RWL, where the first direction X intersects with the second direction Y

It should be noted that the second manner, the third manner, and the fourth manner have a same technical effect as the first manner. For details, refer to the foregoing description of the technical effect of the first manner. Details are not described herein again.

Based on the foregoing descriptions, for each layer of storage array 201, a quantity of storage cells 201A along the first direction X and/or the second direction Y may be increased, to implement a larger-scale storage array.

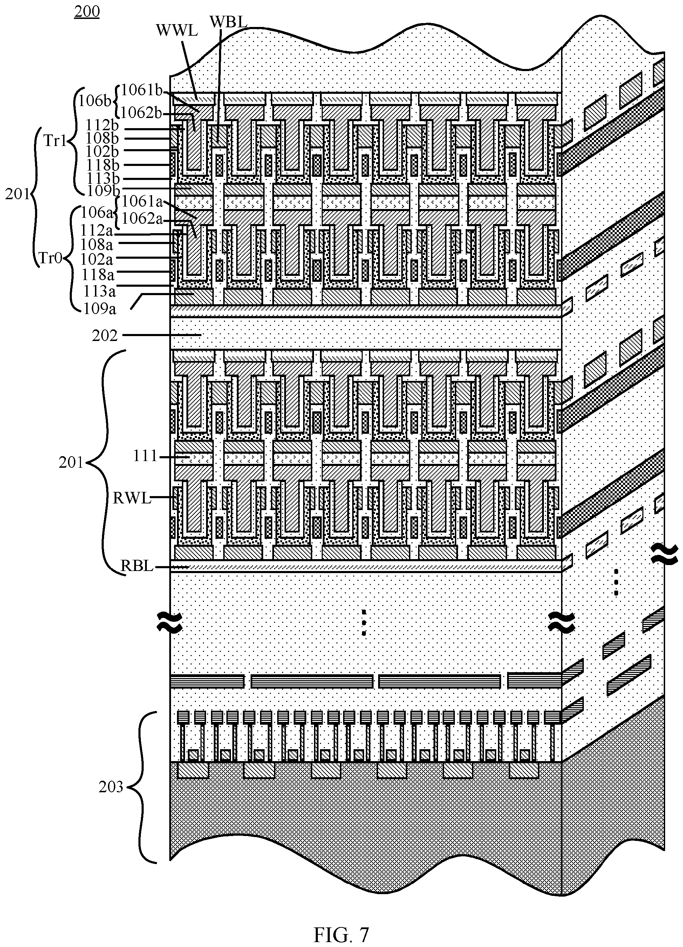

Refer to FIG. 7, in some embodiments, the memory 200 further includes an integrated circuit 203, and the storage array 201 is disposed on the integrated circuit 203. In this case, the memory 200 is an on-chip memory. In this case, the substrate in the memory 200 is the integrated circuit 203.

A substrate of the integrated circuit 203 may be a silicon substrate, that is, the integrated circuit 203 may be an integrated circuit on a silicon substrate

In addition, the integrated circuit 203 may be a control circuit of the storage array 201, or may be another functional circuit.

It should be noted that, because a process temperature of manufacturing a thin film transistor is relatively low, the storage array 201 may be integrated into a back end of line of the integrated circuit 203. In addition, stacking of a plurality of layers of storage arrays 201 may be implemented on the integrated circuit 203, so as to implement 3D system integration.

In some examples, the storage cell 201A in the storage array 201 may be electrically connected to the integrated circuit 203. For example, the storage cell 201A in the storage array 201 may be connected to the lower integrated circuit 203 by using an interconnection line.

An embodiment of this application further provides a thin film transistor 10. The thin film transistor may be used as the foregoing first thin film transistor Tr0, or may be used as the foregoing second thin film transistor Tr1.

A structure of the thin film transistor 10 is described in detail below.

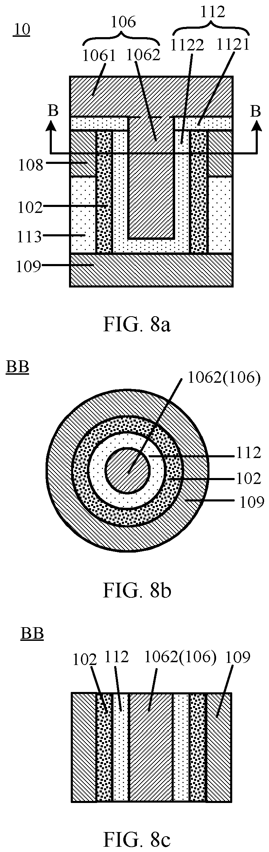

Refer to FIG. 8a, FIG. 8b, and FIG. 8c, the thin film transistor 10 includes a gate 106, a first electrode 109, a second electrode 108, a first dielectric layer 113, a second dielectric layer 112, and a semiconductor layer 102.

The gate 106 includes a gate base 1061 located at a top portion and a gate body 1062 extending from the gate base 1061 to a bottom portion. The first electrode 109 is located at the bottom portion. The second electrode 108 is located between the first electrode 109 and the gate base 1061. The first dielectric layer 113 is disposed between the second electrode 108 and the first electrode 109, and the first dielectric layer 113 is configured to separate the first electrode 109 from the second electrode 108. The second dielectric layer 112 covers a surface of the gate base 1061 and a surface of the gate body 1062. The semiconductor layer 102 is disposed along a side surface of the gate body 1062, and the second dielectric layer 112 separates the semiconductor layer 102 from the gate 106. The first electrode 109 and the second electrode 108 are electrically connected to the semiconductor layer 102 respectively.

FIG. 8b is a schematic cross-sectional view along a direction BB in FIG. 8a, and FIG. 8c is another schematic cross-sectional view along a direction BB in FIG. 8a.

As shown in FIG. 8a and FIG. 8b, the second dielectric layer 112 surrounds an outer side of the gate body 1062 on the first electrode 109, the semiconductor layer 102 surrounds an outer side of the second dielectric layer 112, and the second electrode 108 is disposed on an outer side the semiconductor layer 102 and is electrically connected to the semiconductor layer 102. The second electrode 108 is on the first electrode 109 and is separated by the first dielectric layer 113, and the first electrode 109 is electrically connected to the semiconductor layer 102.

It should be noted that the gate body 1062 includes a surface in contact with the gate base 1061, a surface away from the gate base 1061, and a side surface. The surface in contact with the gate base 1061 and the surface away from the gate base 1061 are disposed opposite to each other.

In some embodiments, the gate body 1062 and the gate base 1061 are integrally formed. In some other embodiments, the gate body 1062 and the gate base 1061 are separately manufactured.

In some examples, the gate body 1062 is disposed perpendicular to the gate base 1061.

The first electrode 109 forms ohmic contact with the semiconductor layer 102, and the second electrode 108 forms ohmic contact with the semiconductor layer 102. In addition, that the first electrode 109 is electrically connected to the semiconductor layer 102 may be that the first electrode 109 is in direct contact with the semiconductor layer 102, or may be that the first electrode 109 is not in direct contact with the semiconductor layer 102, but is electrically connected to the semiconductor layer 102 by using another medium. Similarly, that the second electrode 108 is electrically connected to the semiconductor layer 102 may be that the second electrode 108 is in direct contact with the semiconductor layer 102, or may be that the second electrode 108 is not in direct contact with the semiconductor layer 102, but is electrically connected to the semiconductor layer 102 by using another medium.

It should be noted that the first electrode 109 in the thin film transistor 10 may be a drain, and the second electrode 108 may be a source; or the first electrode 109 in the thin film transistor 10 may be a source, and the second electrode 108 may be a drain.

In addition, the thin film transistor 10 may be an N-type transistor or may be a P-type transistor.

In addition, because the second dielectric layer 112 covers the surface of the gate base 1061 and the surface of the gate body 1062, as shown in FIG. 8a, the second dielectric layer 112 includes a first dielectric part 1121 and a second dielectric part 1122, where the first dielectric part 1121 covers the surface of the gate base 1061, and the second dielectric part 1122 covers the surface of the gate body 1062.

Based on this, in some embodiments, the first dielectric part 1121 and the second dielectric part 1122 are synchronously manufactured. In some other embodiments, the first dielectric part 1121 and the second dielectric part 1122 may be separately manufactured.

Considering that if a distance between the first electrode 109 and the second electrode 108 is too short, there may be a risk that the first electrode 109 and the second electrode 108 are directly conducted when the first electrode 109 and the second electrode 108 are manufactured. To avoid direct conduction of the first electrode 109 and the second electrode 108, in some embodiments, the second electrode 108 is disposed close to the gate base 1061.

It should be understood that materials of the gate 106, the first electrode 109, and the second electrode 108 are all conductive materials, for example, metal materials. Specifically, the materials of the gate 106, the first electrode 109, and the second electrode 108 may be one or more of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (argentum).

For the material of the first dielectric layer 113 and the material of the second dielectric layer 112, refer to the material of the sixth dielectric layer 202. Details are not described herein again. In addition, the first dielectric layer 113 and the second dielectric layer 112 each may be a single-layer structure, or may be a multi-layer stacked structure.

A material of the semiconductor layer 102 may be one or more of semiconductor materials such as Si (silicon), poly-Si (p-Si, polysilicon), amorphous-Si (a-Si, amorphous silicon), In-Ga-Zn-O (IGZO, indium gallium zinc oxide) poly-compound, ZnO (zinc oxide), ITO, TiO₂ (titanium dioxide), and MoS₂ (molybdenum disulfide).

An embodiment of this application provides a thin film transistor 10. The gate 106 of the thin film transistor 10 includes the gate base 1061 located at the top portion and the gate body 1062 extending from the gate base 1061 to the bottom portion. The semiconductor layer 102 is disposed along the side of the gate body 1062, the first electrode 109 is located at the bottom portion, the second electrode 108 is located between the first electrode 109 and the gate base 1061, and the first electrode 109 and the second electrode 108 are electrically connected to the semiconductor layer 102 respectively. In the conventional technology, the semiconductor layer 102 is disposed along a plane parallel to the gate 106 (the gate 106 in the conventional technology is equivalent to the gate base 1061 in this embodiment of this application), and the second electrode 108 and the first electrode 109 are disposed at a same layer, so that a size of the thin film transistor 10 provided in this embodiment of this application is relatively small on the plane parallel to the gate base 1061. Therefore, in this embodiment of this application, a size of the thin film transistor 10 is reduced, and area utilization is improved. In addition, because the second electrode 108 and the first electrode 109 of the thin film transistor 10 in this embodiment of this application are located at different layers, a short circuit occurring during routing of a signal line electrically connected to the second electrode 108 and a signal line electrically connected to the first electrode 109 may be avoided, thereby reducing process difficulty.

When structures of the first thin film transistor Tr0 and the second thin film transistor Tr1 in the memory 200 are the foregoing thin film transistor 10, sizes of the first thin film transistor Tr0 and the second thin film transistor Tr1 in the memory 200 can be reduced, and area utilization can be improved.

For a structure of the gate 106, the following three implementations may be used as examples.

First implementation: As shown in FIG. 8a, FIG. 9, FIG. 10, and FIG. 11, a boundary of a projection of the gate body 1062 on the gate base 1061 is located within a boundary of the gate base 1061, that is, the gate body 1062 is disposed in a middle region of the gate base 1061.

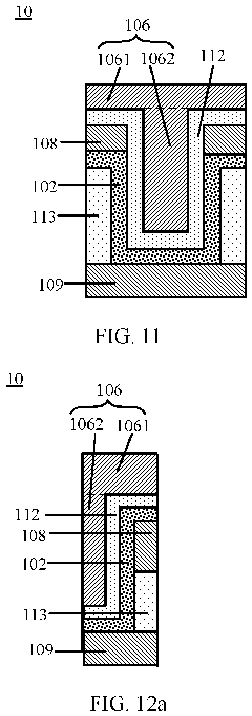

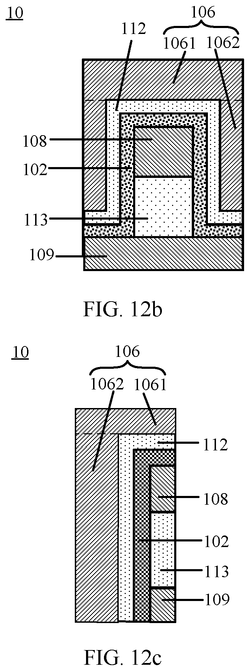

Second implementation: As shown in FIG. 12a and FIG. 12c, a boundary of a projection of the gate body 1062 on the gate base 1061 partially overlaps a boundary of the gate base 1061, that is, the gate body 1062 is disposed in an edge region of the gate base 1061.

Third implementation: As shown in FIG. 12b, the gate body 1062 is of a hollow structure, and an outer boundary of a projection of the gate body 1062 on the gate base 1061 overlaps a boundary of the gate base 11061.

It should be understood that, because the gate body 1062 is of a hollow structure, the projection of the gate body 1062 on the gate base 1061 includes two boundaries: an outer boundary and an inner boundary. A boundary close to a center of the gate base 1061 is referred to as an inner boundary, and a boundary away from the center of the gate base 10161 is referred to as an outer boundary.

In addition, because the gate body 1062 is of a hollow structure, and the outer boundary of the projection of the gate body 1062 on the gate base 1061 overlaps the boundary of the gate base 11061, at least a part of a region of the second dielectric layer 112 is located in the hollow structure, at least a part of a region of the semiconductor layer 102 is located in the hollow structure, the second electrode 108 is located in the hollow structure, and at least a part of a region of the first dielectric layer 113 is located in the hollow structure.

In a case that the gate body 1062 is of a hollow structure, the gate 106 regulates and controls a current in the semiconductor layer 102 from the outer side of the semiconductor layer 102.

For a structure of the semiconductor layer 102, the following four implementations may be used as examples.

First implementation: As shown in FIG. 8a, the semiconductor layer 102 is disposed only along the side surface of the gate body 1062.

As shown in FIG. 8a, the semiconductor layer 102 surrounds only the side surface of the gate body 1062 and is disposed on the first electrode 109.

The second electrode 108 and the first electrode 109 are electrically connected to or in end contact with the semiconductor layer 102.

Second implementation: As shown in FIG. 12c, the semiconductor layer 102 is disposed along the side surface of the gate body 1062, and the semiconductor layer 102 further includes an extension portion extending along the surface of the gate base 1061. The second dielectric layer 112 separates the semiconductor layer 102 from the gate 106. In addition, as shown in FIG. 12c, the semiconductor layer 102 is disposed on a side surface of the first dielectric layer 113 and a side surface of the second electrode 108, and covers a top surface of the second electrode 108.

In some examples, as shown in FIG. 12c, the semiconductor layer 102 is further disposed on a side surface of the first electrode 109.

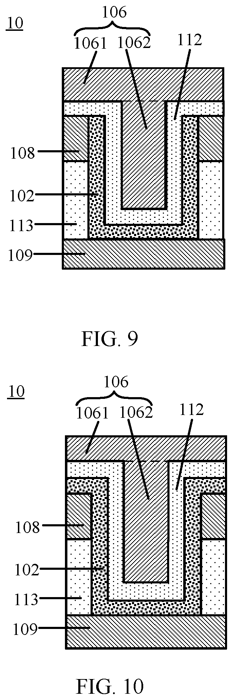

Third implementation: As shown in FIG. 9, the semiconductor layer 102 is disposed along the side surface of the gate body 1062, and the semiconductor layer 102 extends from the side surface of the gate body 1062 to a side of the gate body 1062 that is away from the gate base 1061, that is, is located between the gate body 1062 and the first electrode 109. That is, the semiconductor layer 102 further includes an extension portion located between the gate body 1062 and the first electrode 109. In addition, as shown in FIG. 9, the semiconductor layer 102 covers a side surface of the second dielectric layer 112 and a surface of the bottom portion.

In some examples, as shown in FIG. 9, the semiconductor layer 102 is disposed on the first electrode 109.

Fourth implementation: As shown in FIG. 10, FIG. 11, FIG. 12a, and FIG. 12b, the semiconductor layer 102 is disposed along the side surface of the gate body 1062, and the semiconductor layer 102 further includes an extension portion extending along the surface of the gate base 1061 and an extension portion located between the gate body 1062 and the first electrode 109. In this case, the semiconductor layer 102 is in a "Z" shape. In other words, as shown in FIG. 10, FIG. 12a, and FIG. 12b, the semiconductor layer 102 covers a side surface, a bottom surface, and a top surface of the second dielectric layer 112. Alternatively, as shown in FIG. 11, the semiconductor layer 102 covers a side surface and a bottom surface of the second dielectric layer 112, and further covers a bottom surface of the second electrode 108.

In some examples, as shown in FIG. 10, FIG. 11, FIG. 12a, and FIG. 12b, the semiconductor layer 102 is disposed on the first electrode 109.

In some embodiments, as shown in FIG. 8b, the semiconductor layer 102 is disposed around the entire side surface of the gate body 1062. In this case, the semiconductor layer 102 may surround the entire side surface of the gate body 1062, or the semiconductor layer 102 may surround a part of the side surface of the gate body 1062.

Because the semiconductor layer 102 is disposed around the entire side surface of the gate body 1062, an area of the semiconductor layer 102 may be increased, and carrier mobility may be improved.

For the second electrode 108, in some embodiments, as shown in FIG. 8a, FIG. 9, FIG. 10, FIG. 12a, and FIG. 12b, the second electrode 108 is disposed on a side of the semiconductor layer 102 that is away from the second dielectric layer 112.

It should be understood that, in a case that the semiconductor layer 102 further includes an extension portion extending along the surface of the gate base 1061, when the second electrode 108 is disposed on the side of the semiconductor layer 102 that is away from the second dielectric layer 112, as shown in FIG. 10, FIG. 12a, and FIG. 12b, the second electrode 108 is not in contact with the second dielectric layer 112, and the second electrode 108 and the second dielectric layer 112 are separated by the semiconductor layer 102. In a case that the semiconductor layer 102 is disposed along the side surface of the gate body 1062 and the semiconductor layer 102 does not include an extension portion extending along the surface of the gate base 1061, as shown in FIG. 8a and FIG. 9, when the second electrode 108 is disposed on the side of the semiconductor layer 102 that is away from the second dielectric layer 112, the second electrode 108 is in contact with the second dielectric layer 112.

In some other embodiments, as shown in FIG. 11, the second electrode 108 may be disposed on a side of the semiconductor layer 102 that is close to the second dielectric layer 112. In this case, the second electrode 108 is located between the second dielectric layer 112 and the semiconductor layer 102.

In addition, the second electrode 108 may be disposed around the entire side surface of the gate body 1062, or the second electrode 108 may be disposed around the side surface of the gate body 1062, but is not the entire side surface.

For the first electrode 109, the first electrode 109 is located at the bottom portion, that is, the first electrode 109 is disposed on a side of the second electrode 108 that is away from the gate base 1061. In some embodiments, as shown in FIG. 8a, FIG. 9, FIG. 10, FIG. 11, FIG. 12a, and FIG. 12b, the first electrode 109 is disposed on a side of the gate body 1062 that is away from the gate base 1061. In this case, the semiconductor layer 102 is disposed on the first electrode 109. In some other embodiments, as shown in FIG. 12c, the first electrode 109 is disposed on the side surface of the gate body 1062. In this case, the semiconductor layer 102 may also extend along a side surface of the first electrode 109.

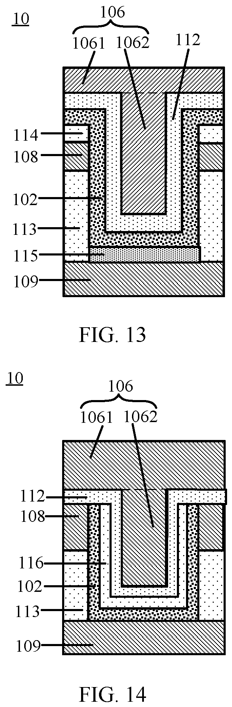

In some embodiments, as shown in FIG. 13, the thin film transistor 10 further includes a fourth dielectric layer 114 disposed between the second electrode 108 and the semiconductor layer 102, and/or a fifth dielectric layer 115 disposed between the first electrode 109 and the semiconductor layer 102.

For a material of the fourth dielectric layer 114 and a material of the fifth dielectric layer 115, refer to the material of the sixth dielectric layer 202. Details are not described herein again. In addition, the fourth dielectric layer 114 and the fifth dielectric layer 115 each may be a single-layer structure, or may be a multi-layer stacked structure.

It should be noted that the fourth dielectric layer 114 is disposed between the second electrode 108 and the semiconductor layer 102, and the second electrode 108 may or may not be in contact with the semiconductor layer 102. The fifth dielectric layer 115 is disposed between the first electrode 109 and the semiconductor layer 102, and the first electrode 109 may or may not be in contact with the semiconductor layer 102.

To ensure that the first electrode 109 and the second electrode 108 can be conducted by using the semiconductor layer 102 when a voltage is provided on the gate 106, in some embodiments, thicknesses of both the fourth dielectric layer 114 and the fifth dielectric layer 115 range from 0.1 nm to 2 nm.

For example, the thicknesses of the fourth dielectric layer 114 and the fifth dielectric layer 115 may be 0.1 nm, 0.5 nm, 1 nm, 1.5 nm, and 2 nm.

Because the thicknesses of the fourth dielectric layer 114 and the fifth dielectric layer 115 are relatively small, and the thicknesses range from 0.1 nm to 2 nm, even if the fourth dielectric layer 114 is disposed between the second electrode 108 and the semiconductor layer 102, and/or the fifth dielectric layer 115 is disposed between the first electrode 109 and the semiconductor layer 102, when a voltage is provided on the gate 106, the first electrode 109 and the second electrode 108 can still be conducted by using the semiconductor layer 102, and performance of the thin film transistor 10 is not affected. In addition, the fourth dielectric layer 114 is disposed between the second electrode 108 and the semiconductor layer 102, so as to avoid a problem of diffusion of the second electrode 108 in a contact region with the semiconductor layer 102, and reduce a Fermi level pinning problem of contact between the second electrode 108 and the semiconductor layer 102. The fifth dielectric layer 115 is disposed between the first electrode 109 and the semiconductor layer 102, so as to avoid a problem of diffusion of the first electrode 109 in a contact region with the semiconductor layer 102, and reduce a Fermi level pinning problem of contact between the first electrode 109 and the semiconductor layer 102.

In some embodiments, a material of the second dielectric layer 112 is a ferroelectric material. In this case, as shown in FIG. 14, the thin film transistor 10 further includes a third dielectric layer 116 disposed between the semiconductor layer 102 and the second dielectric layer 112.

For a material of the third dielectric layer 116, refer to the material of the sixth dielectric layer 202. Details are not described herein again. In addition, the third dielectric layer 116 may be a single-layer structure, or may be a multi-layer stacked structure.

It may be understood that, when the material of the second dielectric layer 112 is a ferroelectric material, the gate 106, the second dielectric layer 112, and the third dielectric layer 116 form a composite gate structure. By using the composite gate structure, the thin film transistor 10 may implement performance of a negative capacitance transistor, and a gate control capability of the thin film transistor 10 may be improved by using the negative capacitance. When the thin film transistor 10 is used in the memory 200, performance of the memory 200 may be improved.

It should be noted that in this embodiment of this application, materials of the first dielectric layer 113, the second dielectric layer 112, the third dielectric layer 116, the fourth dielectric layer 114, and the fifth dielectric layer 115 may be the same or may be different.

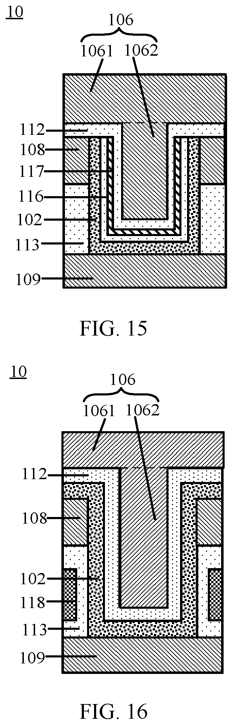

Based on this, when the material of the second dielectric layer 112 is a ferroelectric material, and the thin film transistor 10 includes the third dielectric layer 116, as shown in FIG. 15, the thin film transistor 10 further includes a first conductive layer 117 disposed between the second dielectric layer 112 and the third dielectric layer 116.

For a material of the first conductive layer 117, refer to the materials of the gate 106, the first electrode 109, and the second electrode 108. Details are not described herein again.

A composite gate structure including the gate 106, the second dielectric layer 112, the first conductive layer 117, and the third dielectric layer 116 may enable the thin film transistor 10 to implement performance of a negative capacitance transistor, and a gate control capability of the thin film transistor 10 may be improved by using the negative capacitance. When the thin film transistor 10 is used in the memory 200, performance of the memory 200 may be improved.

In some embodiments, as shown in FIG. 16, the thin film transistor 10 further includes a modulation gate electrode 118 disposed between the first electrode 109 and the second electrode 108, and the modulation gate electrode 118 is surrounded by the first dielectric layer 113.

For a material of the modulation gate electrode 118, refer to the materials of the gate 106, the first electrode 109, and the second electrode 108. Details are not described herein again.

It should be noted that, the modulation gate electrode 118 is surrounded by the first dielectric layer 113, so that the modulation gate electrode 118 is spaced from the first electrode 109, the second electrode 108, and the semiconductor layer 102. That is, the modulation gate electrode 118 is electrically isolated from the first electrode 109, the second electrode 108, and the semiconductor layer 102 by using the first dielectric layer 113.

In this embodiment of this application, because the thin film transistor 10 includes the modulation gate electrode 118, a threshold voltage of the thin film transistor 10 may be adjusted by using the modulation gate electrode 118.

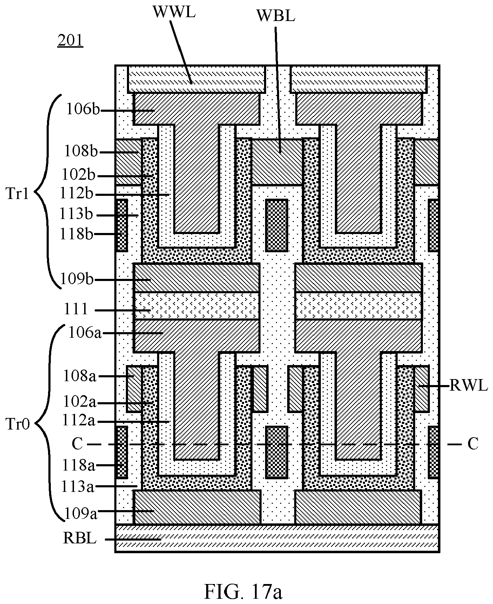

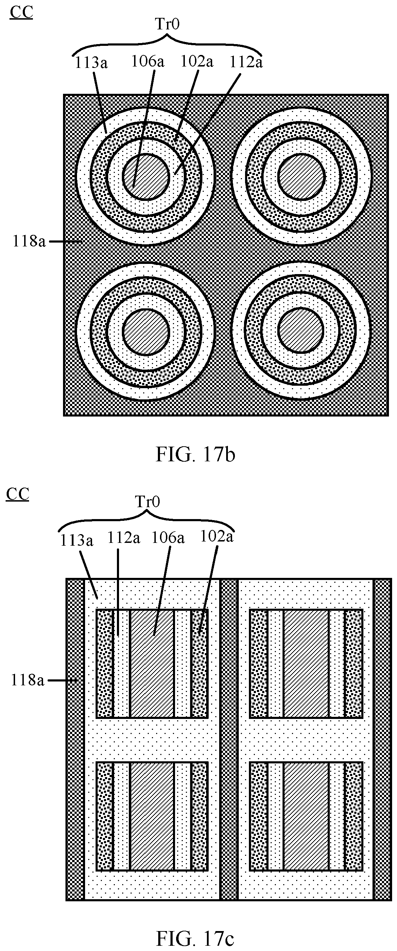

In a case that the thin film transistor 10 is used as the first thin film transistor Tr0 and the second thin film transistor Tr1 in the memory 200, as shown in FIG. 17a, FIG. 17b, and FIG. 17c, in the memory 200, the first thin film transistor Tr0 further includes a first modulation gate electrode 118a disposed between the first electrode 109a and the second electrode 108a, the first modulation gate electrode 118a is disposed on a side of the semiconductor layer 102a that is away from the gate body 1062a, and the first modulation gate electrode 118a is surrounded by the first dielectric layer 113a, so that the first modulation gate electrode 118a is spaced from the first electrode 109a, the second electrode 108a, and the semiconductor layer 102a; and first modulation gate electrodes 118a of a plurality of first thin film transistors Tr0 located at a same layer are electrically connected together; and/or the second thin film transistor Tr1 further includes a second modulation gate electrode 118b disposed between the first electrode 109b and the second electrode 108b, the second modulation gate electrode 118b is disposed on a side of the semiconductor layer 102b that is away from the gate body 1062b, and the second modulation gate electrode 118b is surrounded by the first dielectric layer 113b, so that the second modulation gate electrode 118b is spaced from the first electrode 109b, the second electrode 108b, and the semiconductor layer 102b; and second modulation gate electrodes 118b of a plurality of second thin film transistors Tr1 located at a same layer are electrically connected together.

It should be noted that FIG. 17b and FIG. 17c are both schematic cross-sectional views along a direction CC in FIG. 17a.

The first modulation gate electrodes 118a of the plurality of first thin film transistors Tr0 located at the same layer may be electrically connected together. That is, all the first modulation gate electrodes 118a of the plurality of first thin film transistors Tr0 located at the same layer may be electrically connected together, or some first modulation gate electrodes 118a of the first modulation gate electrodes 118a of the plurality of first thin film transistors Tr0 located at the same layer may be electrically connected together. Similarly, the second modulation gate electrodes 118b of the plurality of second thin film transistors Tr1 located at the same layer may be electrically connected together. That is, the second modulation gate electrodes 118b of the plurality of second thin film transistors Tr1 located at the same layer may be electrically connected together, or some second modulation gate electrodes 118b of the second modulation gate electrodes 118b of the plurality of second thin film transistors Tr1 located at the same layer may be electrically connected together.

For example, as shown in FIG. 17b, the first modulation gate electrodes 118a in the four first thin film transistors Tr0 located at the same layer are electrically connected together. In this way, joint modulation of the four storage cells 201A may be implemented.

It should be noted that, in an actual application, a quantity of jointly modulated storage cells 201A may be selected as required.

For a material of the first modulation gate electrode 118a and a material of the second modulation gate electrode 118b, refer to the materials of the gate 106, the first electrode 109, and the second electrode 108. Details are not described herein again.

The first thin film transistor Tr0 includes the first modulation gate electrode 118a, so that a threshold voltage of the first thin film transistor Tr0 may be adjusted by using the first modulation gate electrode 118a. The second thin film transistor Tr1 includes the second modulation gate electrode 118b, so that a threshold voltage of the second thin film transistor Tr1 may be adjusted by using the second modulation gate electrode 118b. Based on this, storage performance of the memory 200 can be adjusted more flexibly. For example, for the first thin film transistor Tr0, a relatively low potential may be set for the first modulation gate electrode 118a, so that leakage currents of the first electrode 109a and the second electrode 108a of the first thin film transistor Tr0 are reduced, thereby implementing a longer storage and maintenance time. In addition, a relatively high potential may be set for the second modulation gate electrode 118b in the second thin film transistor Tr1, so that an overall current of the second thin film transistor Tr1 is increased, thereby improving a data reading speed.

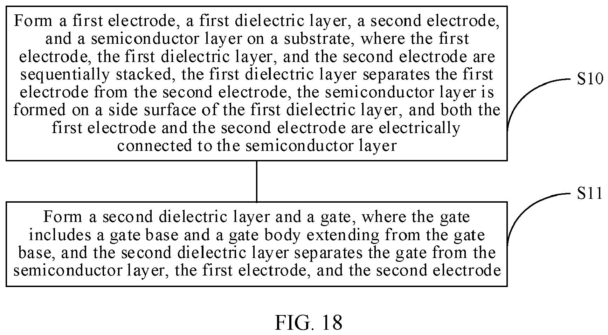

An embodiment of this application further provides a thin film transistor 10 manufacturing method, and the method may be used to manufacture the foregoing thin film transistor 10. Refer to FIG. 18, the thin film transistor 10 manufacturing method includes:

S10. Form a first electrode 109, a first dielectric layer 113, a second electrode 108, and a semiconductor layer 102 on a substrate. The first electrode 109, the first dielectric layer 113, and the second electrode 108 are sequentially stacked, the first dielectric layer 113 separates the first electrode 109 from the second electrode 108, the semiconductor layer 102 is formed on a side surface of the first dielectric layer 113, and both the first electrode 109 and the second electrode 108 are electrically connected to the semiconductor layer 102.

It should be noted that a sequence of forming the first electrode 109, the first dielectric layer 113, the second electrode 108, and the semiconductor layer 102 is not limited.

Both the first electrode 109 and the second electrode 108 may be in direct contact with the semiconductor layer 102, or the first electrode 109 and the second electrode 108 may be in contact with the semiconductor layer 102 through another dielectric layer respectively.

For materials of the first electrode 109, the first dielectric layer 113, the second electrode 108, and the semiconductor layer 102, refer to the foregoing embodiments. Details are not described herein again.

In addition, the first dielectric layer 113 includes a surface close to the second electrode 108, a surface close to the first electrode 109, and a side surface. The surface close to the second electrode 108 and the surface close to the first electrode 109 are disposed opposite to each other.

Based on this, the first electrode 109 may be formed as a drain, and the second electrode 108 may be formed as a source; or the first electrode 109 may be formed as a source, and the second electrode 1081 may be formed as a drain.

S11. Form a second dielectric layer 112 and a gate 106 sequentially, where the gate 106 includes a gate base 1061 located at a top portion and a gate body 1062 extending from the gate base 1061 to a bottom portion, and the second dielectric layer 112 separates the gate 106 from the semiconductor layer 102, the first electrode 109, and the second electrode 108.

For a material of the second dielectric layer 112, refer to the foregoing embodiments. Details are not described herein again.

In addition, for a material of the gate 106, refer to the foregoing embodiments. Details are not described herein again.

It should be noted that the gate base 1061 and the gate body 1062 may be formed simultaneously, or the gate base 1061 and the gate body 1062 may be formed respectively.

Based on the foregoing description, in this embodiment of this application, when the thin film transistor 10 is manufactured, steps S10 and S11 may be performed sequentially, or steps S11 and S10 may be performed sequentially.

An embodiment of this application provides a thin film transistor 10 manufacturing method. Because the thin film transistor 10 manufacturing method provided in this embodiment of this application has a same technical effect as the foregoing thin film transistor 10, refer to the foregoing description. Details are not described herein again.

The following describes a specific implementation of the thin film transistor 10 manufacturing method by using examples.

### Embodiment 1

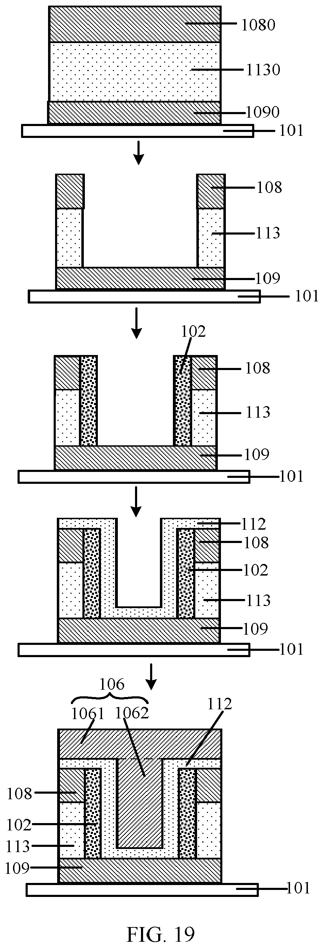

For example, manufacturing a thin film transistor 10 shown in FIG. 8a specifically includes the following steps:
S100. As shown in FIG. 19, sequentially form a first conductive thin film 1090, a first dielectric thin film 1130, and a second conductive thin film 1080 that are stacked on a substrate 101.

The first conductive thin film 1090, the first dielectric thin film 1130, and the second conductive thin film 1080 may be sequentially formed by using a method such as chemical vapor deposition, physical vapor deposition, sputtering, and electroplating.

S101. As shown in FIG. 19, pattern the first conductive thin film 1090, the first dielectric thin film 1130, and the second conductive thin film 1080 to form a first electrode 109, a first dielectric layer 113, and a second electrode 108 that are sequentially stacked, where the first electrode 109, the first dielectric layer 113, and the second electrode 108 form a groove structure.

The first conductive thin film 1090, the first dielectric thin film 1130, and the second conductive thin film 1080 may be patterned by using dry etching or wet etching.

In addition, the first conductive thin film 1090, the first dielectric thin film 1130, and the second conductive thin film 1080 may be etched separately, or the first conductive thin film 1090, the first dielectric thin film 1130, and the second conductive thin film 1080 may be etched simultaneously.

S102. As shown in FIG. 19, form a semiconductor layer 102, where the semiconductor layer 102 is formed on a side wall of the groove structure, that is, the semiconductor layer 102 is formed on a side surface of the first dielectric layer 113 and a side surface of the second electrode 108; and both the first electrode 109 and the second electrode 108 are electrically connected to the semiconductor layer 102.

A semiconductor thin film may be first formed by using an epitaxial growth method, where the semiconductor thin film is an entire layer, and covers exposed surfaces of the first electrode 109, the first dielectric layer 113, and the second electrode 108; and then the semiconductor thin film is etched. In addition to a semiconductor thin film formed on the side wall of the groove, a semiconductor thin film formed on another part such as a bottom portion of the groove, a top surface of the second electrode 108, and an outer side of the groove is etched, so as to form the semiconductor layer 102.

The epitaxial growth method includes, for example, chemical vapor deposition, physical vapor deposition, sputtering, electroplating, and other processes.

S103. As shown in FIG. 19, form a second dielectric layer 112, where the second dielectric layer 112 covers the semiconductor layer 102, the second electrode 108, and the first electrode 109.

It should be noted that step S103 may be implemented in two manners. In a first manner, the second dielectric layer 112 may be directly formed by using a method such as chemical vapor deposition, physical vapor deposition, sputtering, or electroplating. In this case, the second dielectric layer 112 is an entire layer, and covers exposed surfaces of the semiconductor layer 102, the second electrode 108, the first electrode 109, and the first dielectric layer 113. In a second manner, a seventh dielectric thin film may be first formed by using chemical vapor deposition, physical vapor deposition, sputtering, or electroplating, where the seventh dielectric thin film covers exposed surfaces of the semiconductor layer 102, the second electrode 108, the first electrode 109, and the first dielectric layer 113; and then the seventh dielectric thin film is etched. In addition to a part formed on the side surface and the bottom portion of the groove, the top surface of the second electrode 108, and a top surface of the semiconductor layer 102, other seventh dielectric thin films are all etched, so as to form the second dielectric layer 112. The first manner is not shown in the accompanying drawing.

S104. As shown in FIG. 19, form a gate 106, where the gate 106 includes a gate base 1061 and a gate body 1062 extending from the gate base 1061; the gate body 1062 extends into the groove structure, that is, the gate body 1062 extends along the side surface of the first dielectric layer 113 and the side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

A process of forming the gate 106 may be specifically: first forming a conductive thin film, and then etching the conductive thin film to form the gate 106.

### Embodiment 2

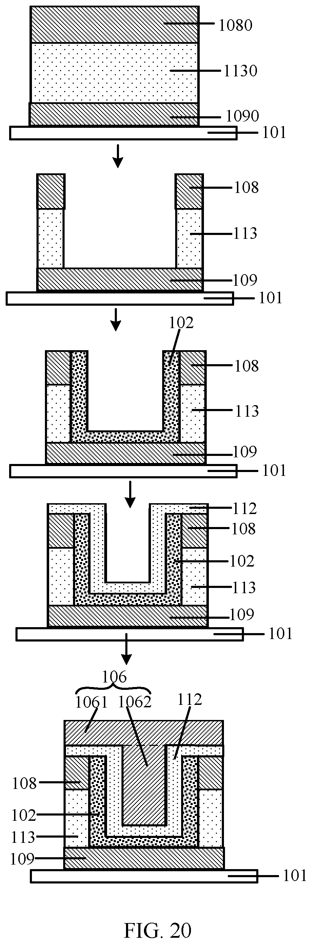

For example, manufacturing a thin film transistor 10 shown in FIG. 9 specifically includes the following steps:
S110. As shown in FIG. 20, sequentially form a first conductive thin film 1090, a first dielectric thin film 1130, and a second conductive thin film 1080 that are stacked on a substrate 101.

For a specific implementation process of step S 110, refer to the foregoing step S100. Details are not described herein again.

S111. As shown in FIG. 20, pattern the first conductive thin film 1090, the first dielectric thin film 1130, and the second conductive thin film 1080 to form a first electrode 109, a first dielectric layer 113, and a second electrode 108 that are sequentially stacked, where the first electrode 109, the first dielectric layer 113, and the second electrode 108 form a groove structure.

For a specific implementation process of step S111, refer to the foregoing step S101 . Details are not described herein again.

5112. As shown in FIG. 20, form a semiconductor layer 102, where the semiconductor layer 102 is formed on a side wall and a bottom portion of the groove structure, that is, the semiconductor layer 102 is formed on a side surface of the first dielectric layer 113 and a side surface of the second electrode 108, and the semiconductor layer 102 further extends from the side surface of the first dielectric layer 113 and the side surface of the second electrode 108 to a surface of a side of the first electrode 109 that is close to the second electrode 108, that is, a top surface of the first electrode 109; and both the first electrode 109 and the second electrode 108 are electrically connected to the semiconductor layer 102.

A semiconductor thin film may be first formed by using an epitaxial growth method, where the semiconductor thin film is an entire layer, and covers exposed surfaces of the first electrode 109, the first dielectric layer 113, and the second electrode 108; and then the semiconductor thin film is etched. In addition to a semiconductor thin film formed on the side wall and the bottom portion of the groove, a semiconductor thin film formed on another part such as a top surface of the second electrode 108 and an outer side of the groove is etched, so as to form the semiconductor layer 102.

S113. As shown in FIG. 20, form a second dielectric layer 112, where the second dielectric layer 112 covers the semiconductor layer 102 and the second electrode 108.

For a specific implementation process of step S113, refer to the foregoing step S103. Details are not described herein again.

S114. As shown in FIG. 20, form a gate 106, where the gate 106 includes a gate base 1061 and a gate body 1062 extending from the gate base 1061; the gate body 1062 extends into the groove structure, that is, the gate body 1062 extends along the side surface of the first dielectric layer 113 and the side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S114, refer to the foregoing step S104. Details are not described herein again.

### Embodiment 3

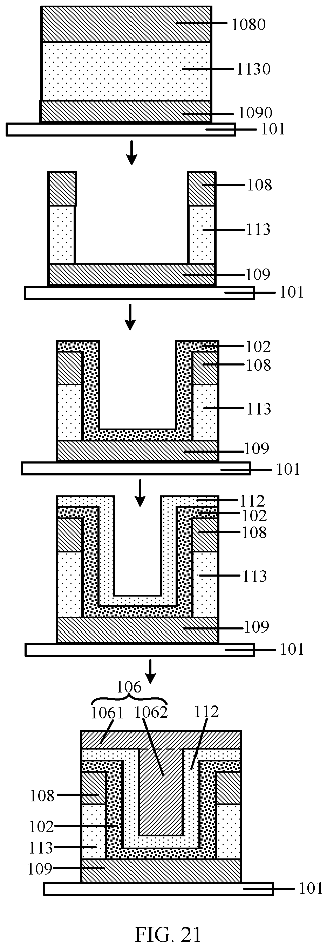

For example, manufacturing a thin film transistor 10 shown in FIG. 10 specifically includes the following steps:
S120. As shown in FIG. 21, sequentially form a first conductive thin film 1090, a first dielectric thin film 1130, and a second conductive thin film 1080 that are stacked on a substrate 101.

For a specific implementation process of step S120, refer to the foregoing step S100. Details are not described herein again.

S121. As shown in FIG. 21, pattern the first conductive thin film 1090, the first dielectric thin film 1130, and the second conductive thin film 1080 to form a first electrode 109, a first dielectric layer 113, and a second electrode 108 that are sequentially stacked, where the first electrode 109, the first dielectric layer 113, and the second electrode 108 form a groove structure.

For a specific implementation process of step S121, refer to the foregoing step S101. Details are not described herein again.

S122. As shown in FIG. 21, form a semiconductor layer 102, where the semiconductor layer 102 is formed on a side wall and a bottom portion of the groove structure, and a surface of a side of the second electrode 108 that is away from the first electrode 109, that is, the semiconductor layer 102 is formed on a side surface of the first dielectric layer 113 and a side surface of the second electrode 108, and the semiconductor layer 102 further extends from the side surface of the first dielectric layer 113 and the side surface of the second electrode 108 to the surface of the side of the second electrode 108 that is away from the first electrode 109 (that is, a top surface of the second electrode 108) and a surface of a side of the first electrode 109 that is close to the second electrode 108 (that is, a top surface of the first electrode 109); and both the first electrode 109 and the second electrode 108 are electrically connected to the semiconductor layer 102.

A semiconductor thin film may be first formed by using an epitaxial growth method, where the semiconductor thin film is an entire layer, and covers exposed surfaces of the first electrode 109, the first dielectric layer 113, and the second electrode 108; and then the semiconductor thin film is etched. In addition to a semiconductor thin film formed on the side wall and the bottom portion of the groove, and the top surface of the second electrode 108, a semiconductor thin film formed on an outer side of the groove is etched, so as to form the semiconductor layer 102.

S123. As shown in FIG. 21, form a second dielectric layer 112, where the second dielectric layer 112 covers the semiconductor layer 102.

For a specific implementation process of step S123, refer to the foregoing step S103. Details are not described herein again.

S124. As shown in FIG. 21, form a gate 106, where the gate 106 includes a gate base 1061 and a gate body 1062 extending from the gate base 1061; the gate body 1062 extends into the groove structure, that is, the gate body 1062 extends along the side surface of the first dielectric layer 113 and the side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S124, refer to the foregoing step S104. Details are not described herein again.

It should be noted that a difference between Embodiment 1, Embodiment 2, and Embodiment 3 lies in a structure of the formed semiconductor layer 102.

### Embodiment 4

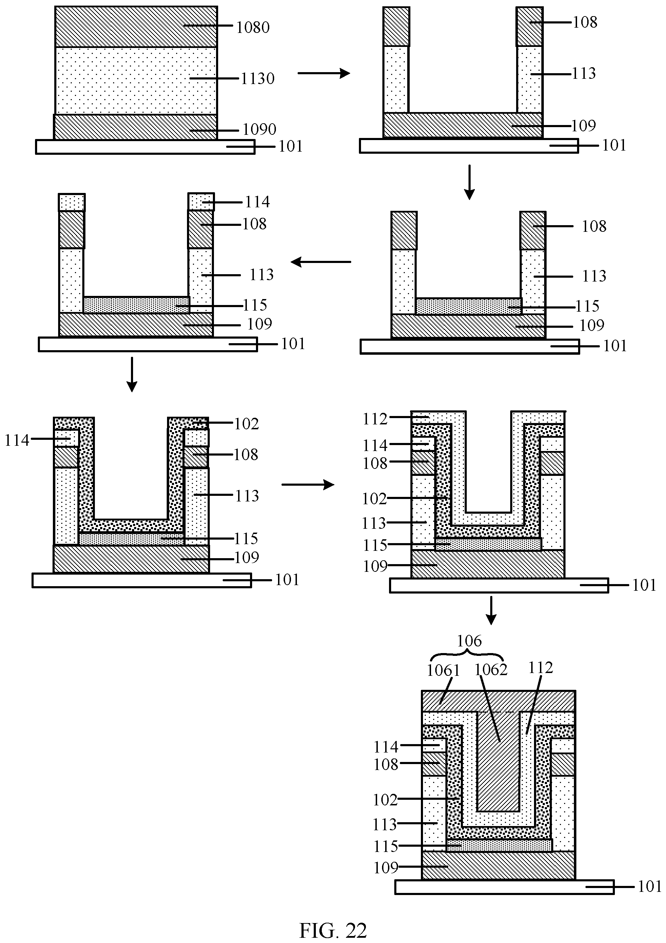

For example, manufacturing a thin film transistor 10 shown in FIG. 13 specifically includes the following steps:
S130. As shown in FIG. 22, sequentially form a first conductive thin film 1090, a first dielectric thin film 1130, and a second conductive thin film 1080 that are stacked on a substrate 101.

For a specific implementation process of step S130, refer to the foregoing step S100. Details are not described herein again.

S131. As shown in FIG. 22, pattern the first conductive thin film 1090, the first dielectric thin film 1130, and the second conductive thin film 1080 to form a first electrode 109, a first dielectric layer 113, and a second electrode 108 that are sequentially stacked, where the first electrode 109, the first dielectric layer 113, and the second electrode 108 form a groove structure.

For a specific implementation process of step S131, refer to the foregoing step S101. Details are not described herein again.

S132. As shown in FIG. 22, form a fifth dielectric layer 115 at a bottom portion of the groove structure, that is, form the fifth dielectric layer 115 on a top surface of the first electrode 109, where the fifth dielectric layer 115 is in contact with the first electrode 109.

A process of forming the fifth dielectric layer 115 may be specifically: first forming a fifth dielectric thin film, and then etching the fifth dielectric thin film to form the fifth dielectric layer 115.

S133. As shown in FIG. 22, form a fourth dielectric layer 114 on a side of the second electrode 108 that is away from the first electrode 109, that is, form the fourth dielectric layer 114 on a top surface of the second electrode 108, where the fourth dielectric layer 114 is in contact with the second electrode 108.

A process of forming the fourth dielectric layer 114 may be specifically: first forming a sixth dielectric thin film, and then etching the sixth dielectric thin film to form the fourth dielectric layer 114.

It should be noted that step S132 and step S133 may be performed step by step. In this case, step S132 may be performed first and then step S133 is performed; or step S133 may be performed first and then step S132 is performed. Step S132 and step S133 may alternatively be synchronously performed, that is, the fourth dielectric layer 114 and the fifth dielectric layer 115 are formed simultaneously.

S134. As shown in FIG. 22, form a semiconductor layer 102, where the semiconductor layer 102 is formed on a side wall and a bottom portion of the groove structure, and a surface of a side of the fourth dielectric layer 114 that is away from the second electrode 108, that is, the semiconductor layer 102 is formed on a side surface of the first dielectric layer 113, a side surface of the second electrode 108, and a side surface of the fourth dielectric layer 114, and the semiconductor layer 102 further extends from the side surface of the first dielectric layer 113, the side surface of the second electrode 108, and the side surface of the fourth dielectric layer 114 to the surface of the side of the fourth dielectric layer 114 that is away from the second electrode 108 (that is, a top surface of the fourth dielectric layer 114) and a surface of a side of the fifth dielectric layer 115 that is away from the first electrode 109 (that is, a top surface of the fifth dielectric layer 115); and the semiconductor layer 102 is in contact with both the fourth dielectric layer 114 and the fifth dielectric layer 115, and both the first electrode 109 and the second electrode 108 are electrically connected to the semiconductor layer 102.

A semiconductor thin film may be first formed by using an epitaxial growth method, where the semiconductor thin film is an entire layer, and covers exposed surfaces of the fourth dielectric layer 114, the fifth dielectric layer 115, the first electrode 109, the first dielectric layer 113, and the second electrode 108; and then the semiconductor thin film is etched. In addition to a semiconductor thin film formed on the side wall and the bottom portion of the groove, and the top surface of the fourth dielectric layer 114, a semiconductor thin film formed on an outer side of the groove is etched, so as to form the semiconductor layer 102.

S135. As shown in FIG. 22, form a second dielectric layer 112, where the second dielectric layer 112 covers the semiconductor layer 102.

For a specific implementation process of step S135, refer to the foregoing step S103. Details are not described herein again.

S136. As shown in FIG. 22, form a gate 106, where the gate 106 includes a gate base 1061 and a gate body 1062 extending from the gate base 1061; the gate body 1062 extends into the groove structure, that is, the gate body 1062 extends along the side surface of the first dielectric layer 113, the side surface of the second electrode 108, and the side surface of the fourth dielectric layer 114; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S136, refer to the foregoing step S104. Details are not described herein again.

It should be noted that, compared with Embodiment 3, step S132 and step S133 are added in Embodiment 4.

In Embodiment 4, both step S132 and step S133 are performed. In some embodiments, one of step S132 and step S133 may alternatively be performed.

In addition, in Embodiment 4, a structure of the semiconductor layer 102 formed in step S134 is the same as a structure of the semiconductor layer 102 formed in Embodiment 3. In some embodiments, a structure of the semiconductor layer 102 formed in step S134 may also be the same as a structure of the semiconductor layer 102 formed in Embodiment 1 or Embodiment 2.

### Embodiment 5

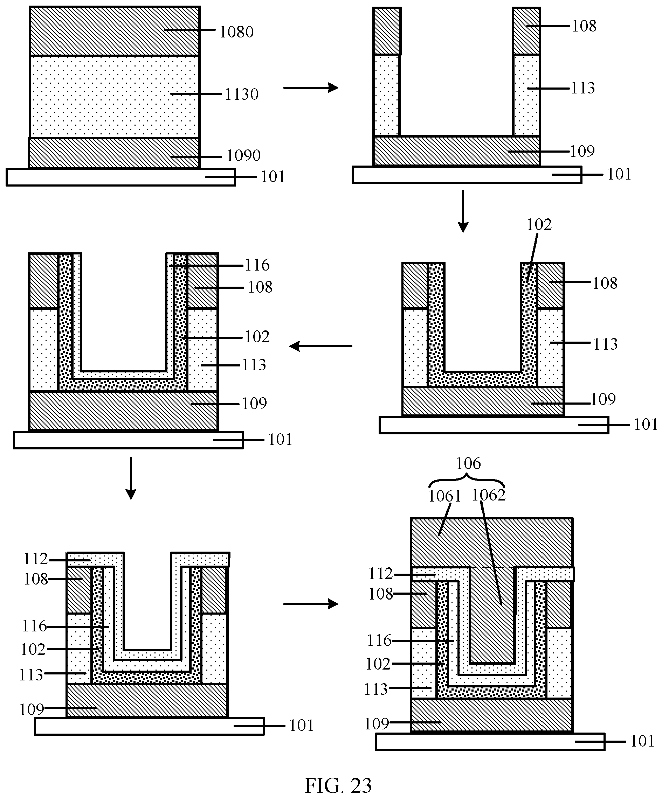

For example, manufacturing a thin film transistor 10 shown in FIG. 14 specifically includes the following steps:
S140. As shown in FIG. 23, sequentially form a first conductive thin film 1090, a first dielectric thin film 1130, and a second conductive thin film 1080 that are stacked on a substrate 101.

For a specific implementation process of step S140, refer to the foregoing step S100. Details are not described herein again.

S141. As shown in FIG. 23, pattern the first conductive thin film 1090, the first dielectric thin film 1130, and the second conductive thin film 1080 to form a first electrode 109, a first dielectric layer 113, and a second electrode 108 that are sequentially stacked, where the first electrode 109, the first dielectric layer 113, and the second electrode 108 form a groove structure.

For a specific implementation process of step S141, refer to the foregoing step S101. Details are not described herein again.

S142. As shown in FIG. 23, form a semiconductor layer 102, where the semiconductor layer 102 is formed on a side wall and a bottom portion of the groove structure, that is, the semiconductor layer 102 is formed on a side surface of the first dielectric layer 113 and a side surface of the second electrode 108, and the semiconductor layer 102 further extends from the side surface of the first dielectric layer 113 and the side surface of the second electrode 108 to a surface of a side of the first electrode 109 that is close to the second electrode 108, that is, a top surface of the first electrode 109; and both the first electrode 109 and the second electrode 108 are electrically connected to the semiconductor layer 102.

For a specific implementation process of step S142, refer to the foregoing step S1 12. Details are not described herein again.

S143. As shown in FIG. 23, form a third dielectric layer 116, where the third dielectric layer 116 is formed on the side wall and the bottom portion of the groove structure.

It should be noted that step S143 may be implemented in two manners. In a first manner, the third dielectric layer 116 may be directly formed by using a method such as chemical vapor deposition, physical vapor deposition, sputtering, or electroplating. In this case, the third dielectric layer 116 is an entire layer, and covers exposed surfaces of the semiconductor layer 102, the second electrode 108, the first electrode 109, and the first dielectric layer 113. In a second manner, an eighth dielectric thin film may be first formed by using chemical vapor deposition, physical vapor deposition, sputtering, or electroplating, where the eighth dielectric thin film covers exposed surfaces of the semiconductor layer 102, the second electrode 108, the first electrode 109, and the first dielectric layer 113; and then the eighth dielectric thin film is etched. In addition to a part formed on the side surface and the bottom portion of the groove, other eighth dielectric thin films are all etched, so as to form the third dielectric layer 116.

S144. As shown in FIG. 23, form a second dielectric layer 112, where the second dielectric layer 112 covers the third dielectric layer 116, the semiconductor layer 102, and the second electrode 108, and a material of the second dielectric layer 112 is a ferroelectric material.

For a specific implementation process of step S144, refer to the foregoing step S103. Details are not described herein again.

S145. As shown in FIG. 23, form a gate 106, where the gate 106 includes a gate base 1061 and a gate body 1062 extending from the gate base 1061; the gate body 1062 extends into the groove structure, that is, the gate body 1062 extends along the side surface of the first dielectric layer 113 and the side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S145, refer to the foregoing step S104. Details are not described herein again.

It should be noted that, compared with Embodiment 2, step S143 is added in Embodiment 5.

In addition, in Embodiment 5, a structure of the semiconductor layer 102 formed in step S142 is the same as a structure of the semiconductor layer 102 formed in Embodiment 2. In some embodiments, a structure of the semiconductor layer 102 formed in step S142 may also be the same as a structure of the semiconductor layer 102 formed in Embodiment 1 or Embodiment 3.

### Embodiment 6

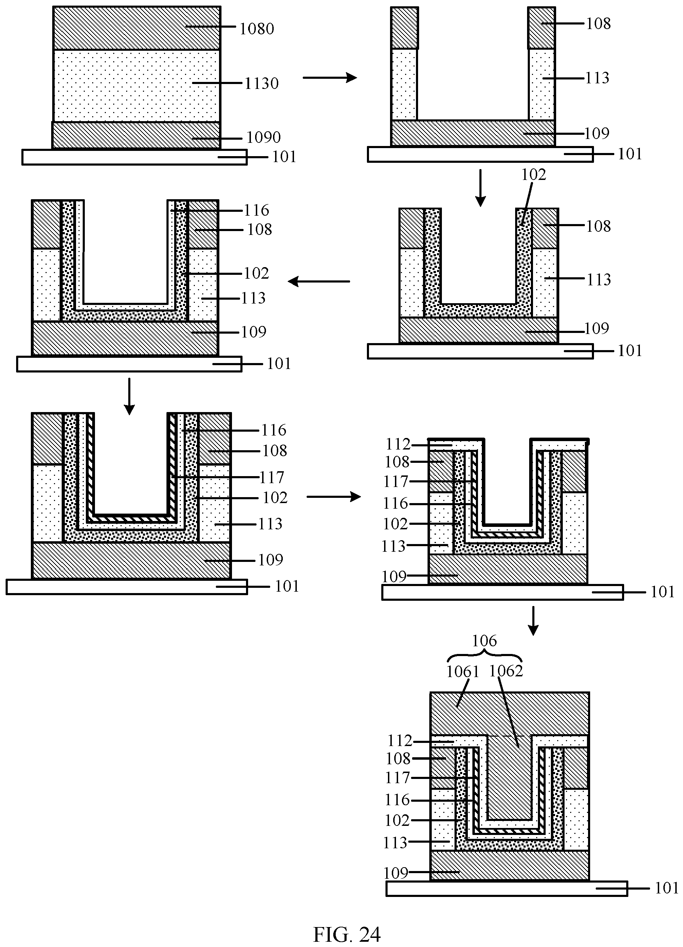

For example, manufacturing a thin film transistor 10 shown in FIG. 15 specifically includes the following steps:
S150. As shown in FIG. 24, sequentially form a first conductive thin film 1090, a first dielectric thin film 1130, and a second conductive thin film 1080 that are stacked on a substrate 101.

For a specific implementation process of step S150, refer to the foregoing step S100. Details are not described herein again.

S151. As shown in FIG. 24, pattern the first conductive thin film 1090, the first dielectric thin film 1130, and the second conductive thin film 1080 to form a first electrode 109, a first dielectric layer 113, and a second electrode 108 that are sequentially stacked, where the first electrode 109, the first dielectric layer 113, and the second electrode 108 form a groove structure.

For a specific implementation process of step S151, refer to the foregoing step S101. Details are not described herein again.

S152. As shown in FIG. 24, form a semiconductor layer 102, where the semiconductor layer 102 is formed on a side wall and a bottom portion of the groove structure, that is, the semiconductor layer 102 is formed on a side surface of the first dielectric layer 113 and a side surface of the second electrode 108, and the semiconductor layer 102 further extends from the side surface of the first dielectric layer 113 and the side surface of the second electrode 108 to a surface of a side of the first electrode 109 that is close to the second electrode 108, that is, a top surface of the first electrode 1109; and both the first electrode 109 and the second electrode 108 are electrically connected to the semiconductor layer 102.

For a specific implementation process of step S152, refer to the foregoing step S112. Details are not described herein again.

S153. As shown in FIG. 24, form a third dielectric layer 116, where the third dielectric layer 116 is formed on the side wall and the bottom portion of the groove structure.

For a specific implementation process of step S153, refer to the foregoing step S143. Details are not described herein again.

S154. As shown in FIG. 24, form a first conductive layer 117, where the first conductive layer 117 is formed on the side wall and the bottom portion of the groove structure.

A fourth conductive thin film may be first formed, where the fourth conductive thin film covers exposed surfaces of the third dielectric layer 116, the semiconductor layer 102, the second electrode 108, the first dielectric layer 113, and the first electrode 109; and then the fourth conductive thin film is etched. In addition to a part formed on the side surface and the bottom portion of the groove, other fourth conductive thin films are etched, so as to form the first conductive layer 117.

S155. As shown in FIG. 24, form a second dielectric layer 112, where the second dielectric layer 112 covers the first conductive layer 117, the second dielectric layer 116, the semiconductor layer 102, and the second electrode 108, and a material of the second dielectric layer 112 is a ferroelectric material.

For a specific implementation process of step S155, refer to the foregoing step S103. Details are not described herein again.

S156. As shown in FIG. 24, form a gate 106, where the gate 106 includes a gate base 1061 and a gate body 1062 extending from the gate base 1061; the gate body 1062 extends into the groove structure, that is, the gate body 1062 extends along the side surface of the first dielectric layer 113 and the side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S156, refer to the foregoing step S104. Details are not described herein again.

It should be noted that, compared with Embodiment 5, step S154 is added in Embodiment 6.

### Embodiment 7

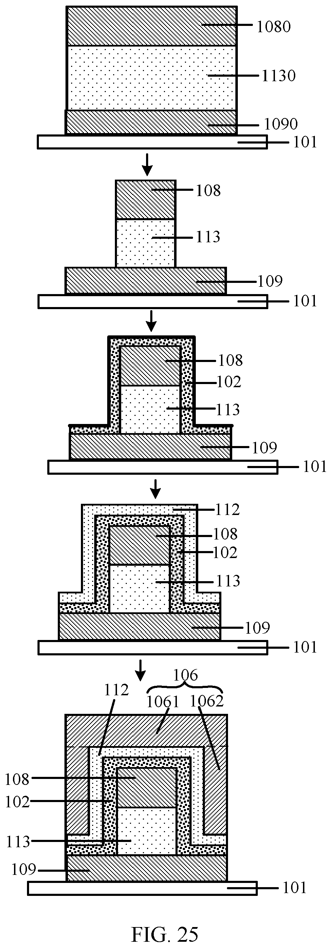

For example, manufacturing a thin film transistor 10 shown in FIG. 12b specifically includes the following steps:
S160. As shown in FIG. 25, sequentially form a first conductive thin film 1090, a first dielectric thin film 1130, and a second conductive thin film 1080 that are stacked on a substrate 101.

For a specific implementation process of step S160, refer to the foregoing step S100. Details are not described herein again.

S161. As shown in FIG. 25, pattern the first conductive thin film 1090, the first dielectric thin film 1130, and the second conductive thin film 1080 to form a first electrode 109, a first dielectric layer 113, and a second electrode 108 that are sequentially stacked, where boundaries of projections of the first dielectric layer 113 and the second electrode 108 on the first electrode 109 are located within a boundary of the first electrode 109, that is, the first dielectric layer 113 and the second electrode 108 are located in a middle region of the first electrode 109.

For a specific implementation process of step S161, refer to the foregoing step S101. Details are not described herein again.

S162. As shown in FIG. 25, form a semiconductor layer 102, where the semiconductor layer 102 covers exposed surfaces of the second electrode 108 and the first dielectric layer 113 and a top surface of the first electrode 109, that is, the semiconductor layer 102 covers a top surface and a side surface of the second electrode 108, a side surface of the first dielectric layer 113, and the top surface of the first electrode 109.

A semiconductor thin film may be first formed by using an epitaxial growth method, where the semiconductor thin film is an entire layer, and covers exposed surfaces of the first electrode 109, the first dielectric layer 113, and the second electrode 108; and then the semiconductor thin film is etched. In addition to a semiconductor thin film formed on the top surface and the side surface of the second electrode 108, the side surface of the first dielectric layer 113, and the top surface of the first electrode 109, a semiconductor thin film formed on another part is etched, so as to form the semiconductor layer 102.

S163. As shown in FIG. 25, form a second dielectric layer 112, where the second dielectric layer 112 covers the semiconductor layer 102.

For a specific implementation process of step S163, refer to the foregoing step S103. Details are not described herein again.

S164. As shown in FIG. 25, form a gate 106, where the gate 106 includes a gate base 1061 and a gate body 1062 extending from the gate base 1061; the gate body 1062 is disposed around the entire side surfaces of the first dielectric layer 113 and the second electrode 108, that is, the gate body 1062 is of a hollow structure, the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S164, refer to the foregoing step S104. Details are not described herein again.

### Embodiment 8

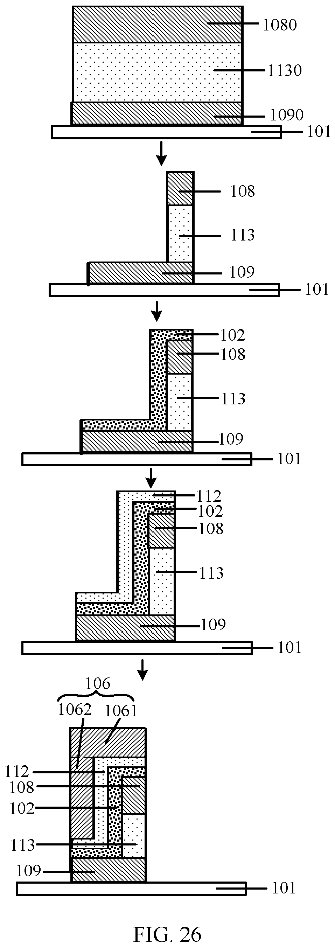

For example, manufacturing a thin film transistor shown in FIG. 12a specifically includes the following steps.
S170. As shown in FIG. 26, sequentially form a first conductive thin film 1090, a first dielectric thin film 1130, and a second conductive thin film 1080 that are stacked on a substrate 101.

For a specific implementation process of step S170, refer to the foregoing step S100. Details are not described herein again.

S171. As shown in FIG. 26, pattern the first conductive thin film 1090, the first dielectric thin film 1130, and the second conductive thin film 1080 to form a first electrode 109, a first dielectric layer 113, and a second electrode 108 that are sequentially stacked, where boundaries of projections of the first dielectric layer 113 and the second electrode 108 on the first electrode 109 partially overlap a boundary of the first electrode 109, that is, the first dielectric layer 113 and the second electrode 108 are located in an edge region of the first electrode 109.

For a specific implementation process of step S171, refer to the foregoing step S101. Details are not described herein again.

S172. As shown in FIG. 26, form a semiconductor layer 102, where the semiconductor layer 102 is formed on a side surface of the second electrode 108 and a side surface of the first dielectric layer 113, and the semiconductor layer 102 further extends from the side surface of the second electrode 108 and the side surface of the first dielectric layer 113 to a top surface of the second electrode 108 and a top surface of the first electrode 109.

A semiconductor thin film may be first formed by using an epitaxial growth method, where the semiconductor thin film is an entire layer, and covers exposed surfaces of the first electrode 109, the first dielectric layer 113, and the second electrode 108; and then the semiconductor thin film is etched. In addition to a semiconductor thin film formed on the side surface of the second electrode 108 and the side surface of the first dielectric layer 113, the top surface of the second electrode 108, and the top surface of the first electrode 109, a semiconductor thin film formed on another part is etched, so as to form the semiconductor layer 102.

S173. As shown in FIG. 26, form a second dielectric layer 112, where the second dielectric layer 112 covers the semiconductor layer 102.

It should be noted that step S173 may be implemented in two manners. In a first manner, the second dielectric layer 112 may be directly formed by using a method such as chemical vapor deposition, physical vapor deposition, sputtering, or electroplating. In this case, the second dielectric layer 112 is an entire layer, and covers exposed surfaces of the semiconductor layer 102, the second electrode 108, the first electrode 109, and the first dielectric layer 113. In a second manner, a seventh dielectric thin film may be first formed by using chemical vapor deposition, physical vapor deposition, sputtering, or electroplating, where the seventh dielectric thin film covers exposed surfaces of the semiconductor layer 102, the second electrode 108, the first electrode 109, and the first dielectric layer 113; and then the seventh dielectric thin film is etched. In addition to a seventh dielectric thin film formed on a surface of a side of the semiconductor layer 102 that is away from the first electrode 109, a seventh dielectric thin film formed on another place is etched, so as to form the second dielectric layer 112. The first manner is not shown in the accompanying drawing.

S174. As shown in FIG. 26, form a gate 106, where the gate 106 includes a gate base 1061 and a gate body 1062 extending from the gate base 1061; the gate body 1062 extends along the side surface of the first dielectric layer 113 and the side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S174, refer to the foregoing step S104. Details are not described herein again.

### Embodiment 9

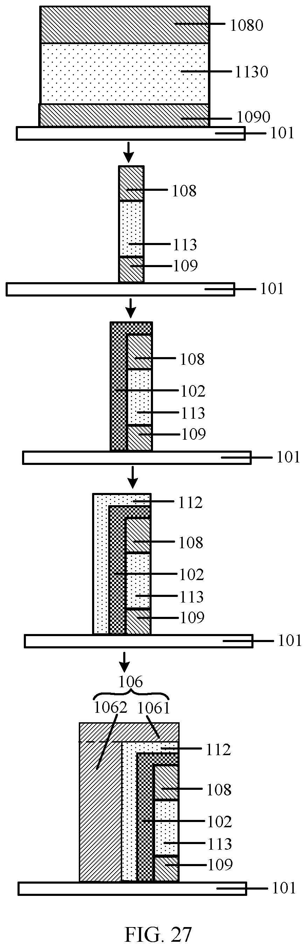

For example, manufacturing a thin film transistor shown in FIG. 12c specifically includes the following steps:
S180. As shown in FIG. 27, sequentially form a first conductive thin film 1090, a first dielectric thin film 1130, and a second conductive thin film 1080 that are stacked on a substrate 101.

For a specific implementation process of step S180, refer to the foregoing step S100. Details are not described herein again.

S181. As shown in FIG. 27, pattern the first conductive thin film 1090, the first dielectric thin film 1130, and the second conductive thin film 1080 to form a first electrode 109, a first dielectric layer 113, and a second electrode 108 that are sequentially stacked, where boundaries of projections of the first dielectric layer 113 and the second electrode 108 on the first electrode 109 overlap a boundary of the first electrode 109.

For a specific implementation process of step S181, refer to the foregoing step S101. Details are not described herein again.

S182. As shown in FIG. 27, form a semiconductor layer 102, where the semiconductor layer 102 is formed on a side surface of the first electrode 109, a side surface of the first dielectric layer 113, and a side surface of the second electrode 108, and the semiconductor layer 102 further extends from the side surface of the first electrode 109, the side surface of the first dielectric layer 113, and the side surface of the second electrode 108 to a surface of a side of the second electrode 108 that is away from the first electrode 109, that is, a top surface of the second electrode 108. A semiconductor thin film may be first formed by using an epitaxial growth method, where the semiconductor thin film is an entire layer, and covers exposed surfaces of the first electrode 109, the first dielectric layer 113, and the second electrode 108; and then the semiconductor thin film is etched. In addition to a semiconductor thin film formed on the left side surface of the first electrode 109, the left side surface of the first dielectric layer 113, the left side surface of the second electrode 108, and the top surface of the second electrode 108, a semiconductor thin film formed on another part is etched, so as to form the semiconductor layer 102.

S183. As shown in FIG. 27, form a second dielectric layer 112, where the second dielectric layer 112 covers the semiconductor layer 102.

It should be noted that step S183 may be implemented in two manners. In a first manner, the second dielectric layer 112 may be directly formed by using a method such as chemical vapor deposition, physical vapor deposition, sputtering, or electroplating. In this case, the second dielectric layer 112 is an entire layer, and covers exposed surfaces of the semiconductor layer 102, the second electrode 108, the first electrode 109, and the first dielectric layer 113. In a second manner, a seventh dielectric thin film may be first formed by using chemical vapor deposition, physical vapor deposition, sputtering, or electroplating, where the seventh dielectric thin film covers exposed surfaces of the semiconductor layer 102, the second electrode 108, the first electrode 109, and the first dielectric layer 113; and then the seventh dielectric thin film is etched. In addition to a seventh dielectric thin film formed on a side surface and a top surface of the semiconductor layer 102, a seventh dielectric thin film formed on another place is etched, so as to form the second dielectric layer 112. The first manner is not shown in the accompanying drawing.

S184. As shown in FIG. 27, form a gate 106, where the gate 106 includes a gate base 1061 and a gate body 1062 extending from the gate base 1061; the gate body 1062 extends along the side surface of the first dielectric layer 113 and the side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S184, refer to the foregoing step S104. Details are not described herein again.

It should be noted that, a difference between Embodiment 7, Embodiment 8, and Embodiment 9 and the foregoing other embodiments lies in that structures of the formed first electrode 109, first dielectric layer 113, and second electrode 108 that are stacked are different.

### Embodiment 10

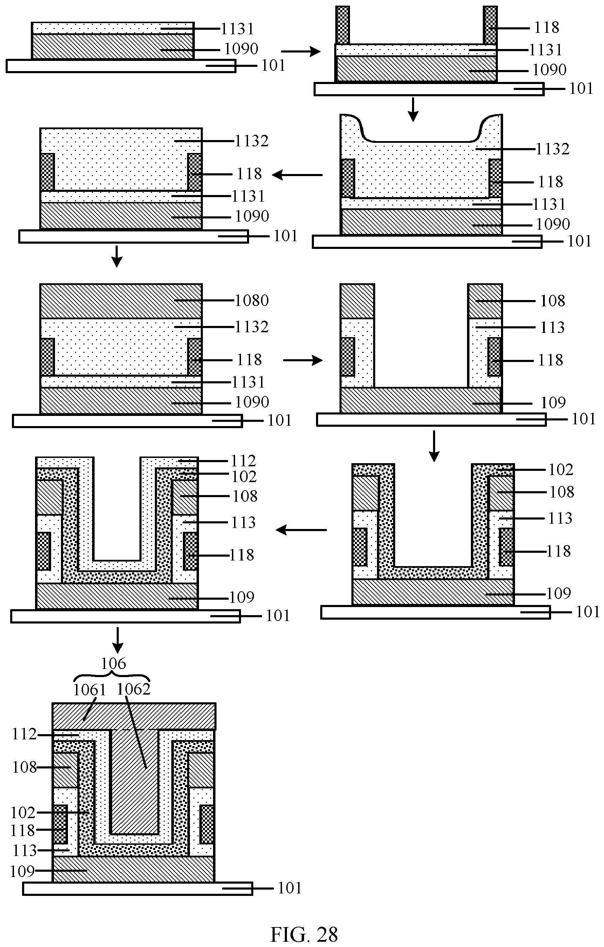

For example, manufacturing a thin film transistor 10 shown in FIG. 16 specifically includes the following steps:
S190. As shown in FIG. 28, form a first conductive thin film 1090 and a third dielectric thin film 1131 that are sequentially stacked on a substrate 101.

For a specific implementation process of step S190, refer to the foregoing step S100. Details are not described herein again.

S191. As shown in FIG. 28, form a modulation gate electrode 118 on the third dielectric thin film 1131.

A specific process of forming the modulation gate electrode 118 may be: first forming a fifth conductive thin film, and then patterning the fifth conductive thin film to form the modulation gate electrode 118.

S192. As shown in FIG. 28, form a fourth dielectric thin film 1132 on the modulation gate electrode 118, where the fourth dielectric thin film 1132 covers the modulation gate electrode 118.

The fourth dielectric thin film 1132 may be formed by using a method such as chemical vapor deposition, physical vapor deposition, sputtering, and electroplating.

S193. As shown in FIG. 28, perform grinding processing on the fourth dielectric thin film 1132.

Grinding processing may be performed on the fourth dielectric thin film 1132 by using a chemical mechanical polishing technology.

It should be noted that step S193 is an optional step. For example, in some embodiments, step S193 may be omitted.

S194. As shown in FIG. 28, form a second conductive thin film 1080 on the fourth dielectric thin film 1132.

The second conductive thin film 1080 may be formed by using a method such as chemical vapor deposition, physical vapor deposition, sputtering, and electroplating.

S195. As shown in FIG. 28, pattern the second conductive thin film 1080 to form a second electrode 108, pattern the fourth dielectric thin film 1132 and the third dielectric thin film 1131 to form a first dielectric layer 113, and pattern the first conductive thin film 1090 to form a first electrode 109, where the second electrode 108, the first dielectric layer 113, and the first electrode 109 form a groove structure, and the first dielectric layer 113 surrounds the modulation gate electrode 118, so that the modulation gate electrode 118 is spaced from the second electrode 108 and the first electrode 109.

For a specific implementation process of step S195, refer to the foregoing step S101. Details are not described herein again.

S196. As shown in FIG. 28, form a semiconductor layer 102, where the semiconductor layer 102 is formed on a side wall and a bottom portion of the groove structure, and a surface of a side of the second electrode 108 that is away from the first electrode 109, that is, the semiconductor layer 102 is formed on a side surface of the first dielectric layer 113 and a side surface of the second electrode 108, and the semiconductor layer 102 further extends from the side surface of the first dielectric layer 113 and the side surface of the second electrode 108 to the surface of the side of the second electrode 108 that is away from the first electrode 109 (that is, a top surface of the second electrode 108) and a surface of a side of the first electrode 109 that is close to the second electrode 108 (that is, a top surface of the first electrode 109); and both the first electrode 109 and the second electrode 108 are electrically connected to the semiconductor layer 102.

For a specific implementation process of step S196, refer to the foregoing step S122. Details are not described herein again.

S197. As shown in FIG. 28, form a second dielectric layer 112, where the second dielectric layer 112 covers the semiconductor layer 102.

For a specific implementation process of step S197, refer to the foregoing step S103. Details are not described herein again.

S198. As shown in FIG. 28, form a gate 106, where the gate 106 includes a gate base 1061 and a gate body 1062 extending from the gate base 1061; the gate body 1062 extends into the groove structure, that is, the gate body 1062 extends along the side surface of the first dielectric layer 113 and the side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S198, refer to the foregoing step S104. Details are not described herein again.

It should be noted that, a difference between Embodiment 10 and the foregoing other embodiments mainly lies in that step S191 is added in Embodiment 10.

### Embodiment 11

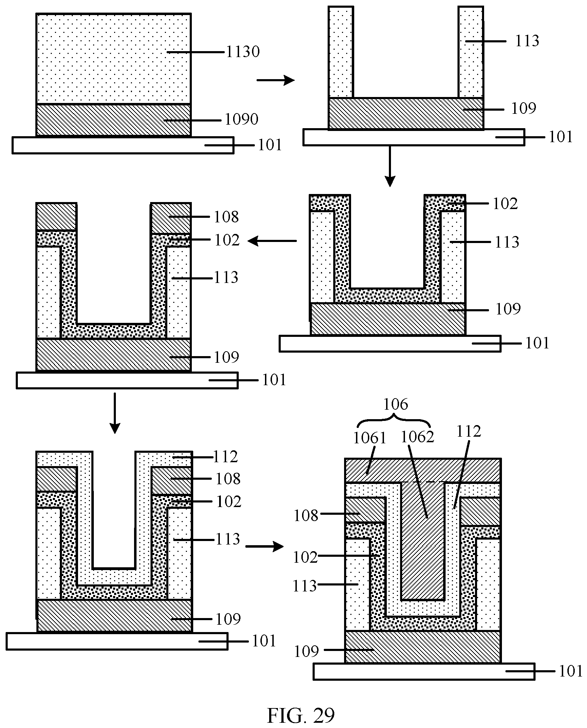

For example, manufacturing a thin film transistor 10 shown in FIG. 11 specifically includes the following steps:
S200. As shown in FIG. 29, form a first conductive thin film 1090 and a first dielectric thin film 1130 that are sequentially stacked on a substrate 101.

For a specific implementation process of step S200, refer to the foregoing step S100. Details are not described herein again.

S201. As shown in FIG. 29, pattern the first conductive thin film 1090 and the first dielectric thin film 1130 to form a first electrode 109 and a first dielectric layer 113 that are sequentially stacked, where the first dielectric layer 113 and the first electrode 109 form a groove structure.

For a specific implementation process of step S201, refer to the foregoing step S101. Details are not described herein again.

S202. As shown in FIG. 29, form a semiconductor layer 102, where the semiconductor layer 102 is formed on a side wall and a bottom portion of the groove structure, and a surface of a side of the first dielectric layer 113 that is away from the first electrode 109, that is, the semiconductor layer 102 is formed on a side surface of the first dielectric layer 113, and the semiconductor layer 102 further extends from the side surface of the first dielectric layer 113 to a surface of a side of the first electrode 109 that is close to the first dielectric layer 113 (that is, a top surface of the first electrode 109) and the surface of the side of the first dielectric layer 113 that is away from the first electrode 109 (that is, a top surface of the first dielectric layer 113); and the first electrode 109 is electrically connected to the semiconductor layer 102.

A semiconductor thin film may be first formed by using an epitaxial growth method, where the semiconductor thin film is an entire layer, and covers exposed surfaces of the first electrode 109 and the first dielectric layer 113; and then the semiconductor thin film is etched. In addition to a semiconductor thin film formed on the side wall and the bottom portion of the groove, and the top surface of the first dielectric layer 113, a semiconductor thin film formed on an outer side of the groove is etched, so as to form the semiconductor layer 102.

S203. As shown in FIG. 29, form a second electrode 108, where the second electrode 108 is located on the side of the first dielectric layer 113 that is away from the first electrode 109, that is, the second electrode 108 is located on the top surface of the first dielectric layer 113.

A process of forming the second electrode 108 may be specifically: first forming a second conductive thin film, and then etching the second conductive thin film to form the second electrode 108.

S204. As shown in FIG. 29, form a second dielectric layer 112, where the second dielectric layer 112 covers the semiconductor layer 102 and the second electrode 108.

It should be noted that step S204 may be implemented in two manners. In a first manner, the second dielectric layer 112 may be directly formed by using a method such as chemical vapor deposition, physical vapor deposition, sputtering, or electroplating. In this case, the second dielectric layer 112 is an entire layer, and covers exposed surfaces of the semiconductor layer 102, the second electrode 108, the first electrode 109, and the first dielectric layer 113. In a second manner, a seventh dielectric thin film may be first formed by using chemical vapor deposition, physical vapor deposition, sputtering, or electroplating, where the seventh dielectric thin film covers exposed surfaces of the semiconductor layer 102, the second electrode 108, the first electrode 109, and the first dielectric layer 113; and then the seventh dielectric thin film is etched. In addition to a part formed on the side surface and the bottom portion of the groove, and a top surface and a side surface of the second electrode 108, other seventh dielectric thin films are all etched, so as to form the second dielectric layer 112. The first manner is not shown in the accompanying drawing.

S205. As shown in FIG. 29, form a gate 106, where the gate 106 includes a gate base 1061 and a gate body 1062 extending from the gate base 1061; the gate body 1062 extends into the groove structure, that is, the gate body 1062 extends along the side surface of the first dielectric layer 113 and a side surface of the second electrode 108; and the gate base 1061 is formed on a side of the gate body 1062 that is away from the first electrode 109, and the second dielectric layer 112 separates the gate 106 from the semiconductor layer 102, the first electrode 109, and the second electrode 108.

For a specific implementation process of step S205, refer to the foregoing step S104. Details are not described herein again.

It should be noted that, a difference between Embodiment 11 and the foregoing other embodiments mainly lies in that a sequence of forming the semiconductor layer 102 and the second electrode 108 in Embodiment 11 is different from that in the foregoing other embodiments.

It should be understood that the thin film transistor 10 provided in embodiments of this application may be manufactured by using the foregoing thin film transistor 10 manufacturing method, or may be manufactured by using another manufacturing method. This is not limited herein.

An embodiment of this application further provides a memory manufacturing method, including forming at least one layer of storage array 201 on a substrate 101.

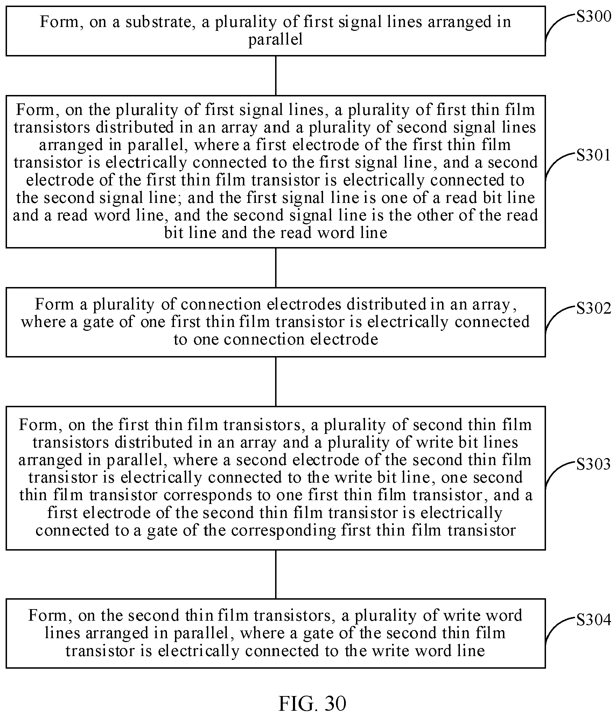

For example, as shown in FIG. 30, manufacturing any layer of storage array 201 shown in FIG. 4 specifically includes the following steps:
S300. Form, on a substrate 101, a plurality of first signal lines arranged in parallel.

S301. Form, on the plurality of first signal lines, a plurality of first thin film transistors Tr0 distributed in an array and a plurality of second signal lines arranged in parallel, where a first electrode 109a of the first thin film transistor Tr0 is electrically connected to the first signal line, and a second electrode 108a of the first thin film transistor Tr0 is electrically connected to the second signal line; and the first signal line is one of a read bit line RBL and a read word line RWL, and the second signal line is the other of the read bit line RBL and the read word line RWL. The first thin film transistor Tr0 may be manufactured by using the thin film transistor 10 manufacturing method provided in any one of the foregoing embodiments. It may be understood that the plurality of first thin film transistors Tr0 distributed in an array herein may be synchronously formed.

It should be noted that the first signal line may be a read bit line RBL, and the second signal line may be a read word line RWL. In this case, the first electrode 109a of the first thin film transistor Tr0 is electrically connected to the read bit line RBL, and the second electrode 108a is electrically connected to the read word line RWL. Alternatively, the first signal line may be a read word line RWL, and the second signal line is a read bit line RBL. In this case, the first electrode 109a of the first thin film transistor Tr0 is electrically connected to the read word line RWL, and the second electrode 108a is electrically connected to the read bit line RBL.

It may be understood that, in some embodiments, the first electrode 109a may be synchronously formed with the first signal line, and the second electrode 108a may be synchronously formed with the second signal line.

S302. Form a plurality of connection electrodes 111 distributed in an array, where a gate 106a of one first thin film transistor Tr0 is electrically connected to one connection electrode 111.

It should be noted that step S302 is an optional step. For example, in some embodiments, step S302 may also be omitted.

A sixth conductive thin film may be first formed, and then the sixth conductive thin film is etched, to form the plurality of connection electrodes 111.

S303. Form, on the first thin film transistors Tr0, a plurality of second thin film transistors Tr1 distributed in an array and a plurality of write bit lines WBLs arranged in parallel, where a second electrode 108b of the second thin film transistor Tr1 is electrically connected to the write bit line WBL. One second thin film transistor Tr1 corresponds to one first thin film transistor Tr0, and a first electrode 109b of the second thin film transistor Tr1 is electrically connected to a gate 106a of the corresponding first thin film transistor Tr0. The second thin film transistor Tr1 may be manufactured by using the thin film transistor 10 manufacturing method provided in any one of the foregoing embodiments. It may be understood that the plurality of second thin film transistors Tr1 distributed in an array herein may be synchronously formed.

It should be noted that, when the manufacturing method of any layer of storage array 201 includes step S302, the first electrode 109b of the second thin film transistor Tr1 is electrically connected to the gate 106a of the corresponding first thin film transistor Tr0 by using the connection electrode 111.

In some embodiments, the second electrode 108b of the second thin film transistor Tr1 may be synchronously formed with the write bit line WBL.

S304. Form a plurality of write word lines WWLs arranged in parallel on the second thin film transistors Tr1, where a gate 106b of the second thin film transistor Tr1 is electrically connected to the write word line WWL.

In some embodiments, the write word line WWL may be synchronously formed with the gate 106b of the second thin film transistor Tr1.

Based on the foregoing description, when the memory 200 includes a plurality of layers of storage arrays 201 disposed on the substrate 101, when the memory 200 is manufactured, steps S300 to S304 may be repeated to form the plurality of layers of storage arrays 201.

In addition, after a first layer of storage array 201 is manufactured, and before a second layer of storage array 201 is formed, the sixth dielectric layer 202 may be first formed. In this case, the sixth dielectric layer 202 is used as a substrate of the second layer of storage array 201. Similarly, before a third layer of storage array 201, a fourth layer of storage array 201, and the like are manufactured, the sixth dielectric layer 202 may also be formed first. The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A thin film transistor, comprising:
a gate, wherein the gate comprises a gate base located at a top portion and a gate body extending from the gate base to a bottom portion;
a first electrode located at the bottom portion;
a second electrode, wherein the second electrode is located between the first electrode and the gate base;
a first dielectric layer, wherein the first dielectric layer is disposed between the second electrode and the first electrode, and the first dielectric layer is configured to separate the second electrode from the first electrode;
a semiconductor layer, wherein the semiconductor layer is disposed along a side surface of the gate body; and
a second dielectric layer, wherein the second dielectric layer separates the semiconductor layer from the gate; and
the first electrode and the second electrode are electrically connected to the semiconductor layer respectively.

2. The thin film transistor according to claim 1, wherein the second electrode is disposed close to the gate base.

3. The thin film transistor according to claim 1 or 2, wherein the semiconductor layer further comprises an extension portion extending along a surface of the gate base.

4. The thin film transistor according to any one of claims 1 to 3, wherein the semiconductor layer further comprises an extension portion located between the gate body and the first electrode.

5. The thin film transistor according to claim 1, wherein the semiconductor layer surrounds an entire side surface of the gate body.

6. The thin film transistor according to claim 1, wherein the second electrode is disposed on a side of the semiconductor layer that is away from the second dielectric layer.

7. The thin film transistor according to claim 1, wherein the second electrode is disposed between the semiconductor layer and the second dielectric layer.

8. The thin film transistor according to claim 1, wherein the thin film transistor further comprises a fourth dielectric layer disposed between the second electrode and the semiconductor layer, and/or a fifth dielectric layer disposed between the first electrode and the semiconductor layer.

9. The thin film transistor according to claim 1, wherein the thin film transistor further comprises a modulation gate electrode disposed between the first electrode and the second electrode, and the modulation gate electrode is surrounded by the first dielectric layer.

10. The thin film transistor according to claim 1, wherein the first electrode is a drain, and the second electrode is a source; or the first electrode is a source, and the second electrode is a drain.

11. A memory, comprising at least one layer of storage array disposed on a substrate, wherein each layer of storage array comprises a plurality of storage cells, write word lines, write bit lines, read word lines, and read bit lines that are distributed in an array; the storage cell comprises a first thin film transistor and a second thin film transistor that are stacked; a first electrode and a second electrode of the first thin film transistor are electrically connected to the read word line and the read bit line respectively; and a gate of the second thin film transistor is electrically connected to the write word line, and a second electrode is electrically connected to the write bit line;
the first thin film transistor and the second thin film transistor are the thin film transistors according to any one of claims 1 to 10; and
a first electrode of the second thin film transistor is close to a gate of the first thin film transistor, and the first electrode of the second thin film transistor is electrically connected to the gate of the first thin film transistor

12. The memory according to claim 11, wherein the storage cell further comprises a connection electrode disposed between the first thin film transistor and the second thin film transistor; and
the gate of the first thin film transistor is electrically connected to the first electrode of the second thin film transistor by using the connection electrode.

13. The memory according to claim 11 or 12, wherein gates of second thin film transistors in a plurality of storage cells that are sequentially arranged in each layer of storage array along a first direction are electrically connected to a same word write line; and
second electrodes of second thin film transistors in a plurality of storage cells that are sequentially arranged in each layer of storage array along a second direction are electrically connected to a same write bit line, wherein
the first direction and the second direction are orthogonal.

14. The memory according to any one of claims 11 to 13, wherein second electrodes of first thin film transistors in the plurality of storage cells that are sequentially arranged in each layer of storage array along the first direction are electrically connected to a same read bit line, and first electrodes of first thin film transistors in the plurality of storage cells that are sequentially arranged in each layer of storage array along the second direction are electrically connected to a same read word line;
second electrodes of first thin film transistors in the plurality of storage cells that are sequentially arranged in each layer of storage array along the first direction are electrically connected to a same read word line, and first electrodes of first thin film transistors in the plurality of storage cells that are sequentially arranged in each layer of storage array along the second direction are electrically connected to a same read bit line;
second electrodes of first thin film transistors in the plurality of storage cells that are sequentially arranged in each layer of storage array along the second direction are electrically connected to a same read bit line, and first electrodes of first thin film transistors in the plurality of storage cells that are sequentially arranged in each layer of storage array along the first direction are electrically connected to a same read word line; or
second electrodes of first thin film transistors in the plurality of storage cells that are sequentially arranged in each layer of storage array along the second direction are electrically connected to a same read word line, and first electrodes of first thin film transistors in the plurality of storage cells that are sequentially arranged in each layer of storage array along the first direction are electrically connected to a same read bit line, wherein
the first direction and the second direction are orthogonal.

15. The memory according to any one of claims 11 to 14, wherein
the first thin film transistor further comprises a first modulation gate electrode disposed between the first electrode and the second electrode, the first modulation gate electrode is surrounded by a first dielectric layer of the first thin film transistor, and first modulation gate electrodes of a plurality of first thin film transistors located at a same layer are electrically connected together; and/or
the second thin film transistor further comprises a second modulation gate electrode disposed between the first electrode and the second electrode, the second modulation gate electrode is surrounded by a first dielectric layer of the second thin film transistor, and second modulation gate electrodes of a plurality of second thin film transistors located at a same layer are electrically connected together.

16. An electronic device, comprising a circuit board and a memory electrically connected to the circuit board, wherein the memory is the memory according to any one of claims 11 to 15.

17. A thin film transistor manufacturing method, comprising:
forming a first electrode, a first dielectric layer, a second electrode, and a semiconductor layer on a substrate, wherein the first electrode, the first dielectric layer, and the second electrode are sequentially stacked, the first dielectric layer separates the first electrode from the second electrode, the semiconductor layer is formed on a side surface of the first dielectric layer, and both the first electrode and the second electrode are electrically connected to the semiconductor layer; and
forming a second dielectric layer and a gate sequentially, wherein the gate comprises a gate base located at a top portion and a gate body extending from the gate base to a bottom portion, and the second dielectric layer separates the gate from the semiconductor layer, the first electrode, and the second electrode.

18. The manufacturing method according to claim 17, wherein the first electrode is formed as a drain, and the second electrode is formed as a source; or
the first electrode is formed as a source, and the second electrode is formed as a drain.

19. The manufacturing method according to claim 17 or 18, wherein the forming a first electrode, a first dielectric layer, a second electrode, and a semiconductor layer on a substrate comprises:
sequentially forming a first conductive thin film, a first dielectric thin film, and a second conductive thin film that are stacked on the substrate;
patterning the first conductive thin film, the first dielectric thin film, and the second conductive thin film to form the first electrode, the first dielectric layer, and the second electrode that are sequentially stacked; and
forming the semiconductor layer on the side surface of the first dielectric layer and a side surface of the second electrode.

20. The manufacturing method according to claim 17 or 18, wherein the forming a first electrode, a first dielectric layer, a second electrode, and a semiconductor layer on a substrate comprises:
forming a first conductive thin film and a third dielectric thin film that are sequentially stacked on the substrate;
forming a modulation gate electrode on the third dielectric thin film;
forming a fourth dielectric thin film, wherein the fourth dielectric thin film surrounds the modulation gate electrode;
forming a second conductive thin film on the fourth dielectric thin film;
patterning the first conductive thin film to form the first electrode, patterning the fourth dielectric thin film and the third dielectric thin film to form the first dielectric layer, and patterning the second conductive thin film to form the second electrode; and
forming the semiconductor layer on the side surface of the first dielectric layer and a side surface of the second electrode.

21. The manufacturing method according to claim 17 or 18, wherein the forming a first electrode, a first dielectric layer, a second electrode, and a semiconductor layer on a substrate comprises:
forming a first conductive thin film and a first dielectric thin film that are sequentially stacked on the substrate;
patterning the first conductive thin film and the first dielectric thin film to form the first electrode and the first dielectric layer that are sequentially stacked;
forming the semiconductor layer on the side surface of the first dielectric layer; and
forming the second electrode on the first dielectric layer.

22. The manufacturing method according to any one of claims 17 to 21, wherein after the first electrode is formed and before the semiconductor layer is formed, the manufacturing method further comprises:
forming a fifth dielectric layer, wherein the fifth dielectric layer is in contact with the first electrode and the semiconductor layer respectively.

23. The manufacturing method according to any one of claims 17 to 22, wherein after the second electrode is formed and before the semiconductor layer is formed; or after the semiconductor layer is formed and before the second electrode is formed, the manufacturing method further comprises:
forming a fourth dielectric layer, wherein the fourth dielectric layer is in contact with the second electrode and the semiconductor layer respectively.

24. A memory manufacturing method, comprising: forming at least one layer of storage array on a substrate; and a manufacturing method of any layer of storage array comprising:
forming, on the substrate, a plurality of first signal lines arranged in parallel;
forming, on the plurality of first signal lines, a plurality of first thin film transistors distributed in an array and a plurality of second signal lines arranged in parallel, wherein the first thin film transistor is manufactured by using the manufacturing method according to any one of claims 17 to 23, a first electrode of the first thin film transistor is electrically connected to the first signal line, and a second electrode of the first thin film transistor is electrically connected to the second signal line; and the first signal line is one of a read bit line and a read word line, and the second signal line is the other of the read bit line and the read word line;
forming, on the first thin film transistors, a plurality of second thin film transistors distributed in an array and a plurality of write bit lines arranged in parallel, wherein a second electrode of the second thin film transistor is electrically connected to the write bit line, the second thin film transistor is manufactured by using the manufacturing method according to any one of claims 17 to 23, one second thin film transistor corresponds to one first thin film transistor, and a first electrode of the second thin film transistor is electrically connected to a gate of the corresponding first thin film transistor; and
forming, on the second thin film transistors, a plurality of write word lines arranged in parallel, wherein a gate of the second thin film transistor is electrically connected to the write word line.

25. The memory manufacturing method according to claim 24, wherein after the forming, on the plurality of first signal lines, a plurality of first thin film transistors distributed in an array and a plurality of second signal lines arranged in parallel, and before the forming, on the first thin film transistors, a plurality of second thin film transistors distributed in an array and a plurality of write bit lines arranged in parallel, the manufacturing method of any layer of storage array further comprises:
forming a plurality of connection electrodes distributed in an array, wherein a gate of the first thin film transistor is electrically connected to a first electrode of the corresponding second thin film transistor by using the connection electrode.
